# EUROPÄISCHE PATENTANMELDUNG

(11) **EP 4 765 508 A1**
(43) Veröffentlichungstag der Anmeldung: **24.06.2026**
(21) Anmeldenummer: 25225741.5
(22) Anmeldetag: 19.12.2025
(51) Int. Cl.: H01R 13/504, H01R 13/516, H01R 13/52, H01R 13/633, H01R 24/62

(54) **USB-C KOPPELVORRICHTUNG, USB-C STECKVERBINDER, USB-C STECKVERBINDERSYSTEM UND VERFAHREN ZUR HERSTELLUNG EINES USB-C STECKVERBINDERS**

(30) Priorität: 20.12.2024 DE 102024139142
(71) Anmelder: Yamaichi Electronics Deutschland GmbH, 85609 Aschheim-Dornach (DE)
(72) Erfinder: Pannagl, Andreas, 85640 Putzbrunn (DE)
(74) Vertreter: Müller-Boré & Partner Patentanwälte PartG mbB

(57) **Zusammenfassung**

Die vorliegende Erfindung betrifft eine USB-C Koppelvorrichtung, einen USB-C Steckverbinder (10; 50), ein USB-C Steckverbindersystem (1), sowie ein Verfahren zur Herstellung eines USB-C Steckverbinders (10; 50), wobei die USB-C Koppelvorrichtung umfasst:
- ein Koppelgehäuse (20; 60);
-eine Aufnahme (30; 70), welche an einem vorderen Abschnitt des Koppelgehäuses (20; 60) gehalten ist, und welche ausgebildet ist, ein USB-C Koppelelement (40; 80), welches einen USB-C Anschluss aufweist, aufzunehmen;
-- wobei die Aufnahme (30; 70) einen Hohlkörper (33; 73) mit einer Öffnung (35; 75) in Steckrichtung (S; S') der Koppelvorrichtung aufweist,
-- wobei das USB-C Koppelelement (40; 80) abschnittsweise in der Öffnung (35; 75) des Hohlkörpers (33; 73) anordenbar ist, so dass das USB-C Koppelelement (40; 80) zumindest teilweise in einen Hohlraum (34; 74) des Hohlkörpers (33; 73) ragt, und
-- wobei der Hohlkörper (33; 73) zumindest abschnittsweise mit einer Vergussmasse (15; 55) befüllbar ist, derart, dass das USB-C Koppelelement (40; 80) fixiert ist.

## Beschreibung

Die vorliegende Erfindung betrifft eine USB-C Koppelvorrichtung, einen USB-C Steckverbinder, ein USB-C Steckverbindersystem und ein Verfahren zur Herstellung eines USB-C Steckverbinders.

Aus dem Stand der Technik sind verschiedene Steckverbinder und entsprechende Steckverbindersysteme bekannt, welche verschiedene Anschlüsse zur Kopplung mit einem Speichermedium bereitstellen. Zur Bereitstellung von wasserdichten Steckverbindersystemen ist es ferner bekannt, insbesondere Dichtlippen oder O-Ringe vorzusehen, um einen jeweiligen Anschluss dicht in einem Steckverbinder anzuordnen.

Es ist daher eine Aufgabe der vorliegenden Erfindung, eine USB-C Koppelvorrichtung, einen USB-C Steckverbinder, ein USB-C Steckverbindersystem sowie ein Verfahren zur Herstellung eines USB-C Steckverbinders bereitzustellen, welche eine verbesserte und insbesondere dichte Anbindung eines USB-C Koppelelements aufweist.

Diese Aufgabe wird durch die unabhängigen Patentansprüche gelöst. Bestimmte Ausführungsformen ergeben sich aus den abhängigen Patentansprüchen.

Ein Aspekt der Erfindung betrifft eine USB-C Koppelvorrichtung, insbesondere eine USB-C Koppelvorrichtung für einen USB-C Steckverbinder, insbesondere Rundsteckverbinder, wobei die Koppelvorrichtung umfasst:
- ein Koppelgehäuse;
- eine Aufnahme, welche an oder in einem vorderen Abschnitt des Koppelgehäuses gehalten ist, und welche ausgebildet ist, ein USB-C Koppelelement, welches einen USB-C Anschluss aufweist, aufzunehmen;
   -- wobei die Aufnahme einen Hohlkörper mit einer Öffnung in Steckrichtung der Koppelvorrichtung aufweist,
   -- wobei das USB-C Koppelelement abschnittsweise in der Öffnung des Hohlkörpers anordenbar ist, so dass das USB-C Koppelelement zumindest teilweise in einen Hohlraum des Hohlkörpers ragt, und
   -- wobei der Hohlkörper zumindest abschnittsweise mit einer Vergussmasse befüllbar ist, derart, dass das USB-C Koppelelement fixiert ist.

Der Hohlkörper ist insbesondere derart zumindest abschnittsweise mit der Vergussmasse befüllbar, dass das USB-C Koppelelement an oder in der Aufnahme fixiert ist.

In beispielhaften Ausführungsformen ist der Hohlkörper des Anschlusses insbesondere derart zumindest abschnittsweise mit der Vergussmasse befüllbar, dass das USB-C Koppelelement an der Aufnahme fixiert ist, die Vergussmasse jedoch keine weitere Fixierung zwischen der Aufnahme und dem Koppelgehäuse bildet oder mit anderen Worten bereitstellt.

Der Hohlkörper ist insbesondere zumindest im Bereich des darin hineinragenden USB-C Koppelelements mit der Vergussmasse befüllbar.

In weiteren beispielhaften Ausführungsformen ist der Hohlkörper des Anschlusses insbesondere derart zumindest abschnittsweise mit der Vergussmasse befüllbar, dass das USB-C Koppelelement dicht an der Aufnahme fixiert ist, insbesondere zumindest wasserdicht an der Aufnahme fixiert ist, insbesondere zumindest spritzwasserdicht an oder in der Aufnahme fixiert ist.

Durch die Befüllbarkeit mit der Vergussmasse ist das Koppelelement vorteilhaft einfach an der Aufnahme fixierbar. Insbesondere ist das Koppelelement im Wesentlichen unabhängig von der exakten Position und/oder Ausrichtung des in Steckrichtung rückwärtig in den Hohlraum hineinragenden Teils des Koppelelements an der Aufnahme fixierbar. Dadurch wird die Fixierung des Koppelelements vorteilhaft vereinfacht.

Insbesondere ist die Aufnahme und das Koppelgehäuse ohne strenge, oder mit anderen Worten enge Fertigungstoleranzen fertigbar, da die Fertigungstoleranzen durch die innerhalb der Fertigungstoleranzen gefertigte Aufnahme vorteilhaft durch die Vergussmasse ausgleichbar sind bzw. ausgeglichen werden. Dadurch ist sowohl die Aufnahme, als auch insbesondere das Koppelgehäuse, vorteilhaft kostengünstig, mit insbesondere vergleichsweise großen Fertigungstoleranzen, welche entsprechend einfach einhaltbar sind, herstellbar.

Ferner ist das Koppelelement vorteilhaft dicht an der Aufnahme fixierbar, wodurch insbesondere zumindest der in Steckrichtung rückwärtig in den Hohlraum hineinragende Teil des Koppelelements geschützt anordenbar ist, insbesondere gegen Staub- und/oder Wasserkontakt geschützt anordenbar ist, insbesondere mit einem Schutz nach der Schutzart IP 50, und/oder vorzugsweise insbesondere nach der Schutzart IP 68.

Das Koppelelement kann mittels der Vergussmasse gekapselt sein. Insbesondere kann das Koppelelement mittels der Vergussmasse an der Aufnahme gekapselt sein. Das Koppelelement kann mittels der Vergussmasse insbesondere von einer in Steckrichtung hinteren Seite und/oder umfänglich durch die Vergussmasse gekapselt sein, oder mit anderen Worten an der Aufnahme gekapselt aufgenommen sein, oder mit weiter anderen Worten an der Aufnahme eingekapselt sein. Das Koppelelement kann insbesondere derart durch die Vergussmasse gekapselt an der Aufnahme angeordnet oder befestigt sein, dass sich ein in Steckrichtung hinterer Teil des Koppelelements und/oder ein mit dem Koppelelement verbundenes Kabel entgegen der Steckrichtung durch die Vergussmasse, oder mit anderen Worten aus der Vergussmasse, erstreckt.

Die gekapselte Anordnung des Koppelelements umfasst insbesondere eine zumindest einseitig formschlüssige und/oder stoffschlüssige Befestigung des Koppelelements von einer in Steckrichtung hinteren Seite an der Aufnahme. In beispielhaften Ausführungsformen umfasst die gekapselte Anordnung des Koppelelements eine zumindest zweiseitige formschlüssige und/oder stoffschlüssige Befestigung des Koppelelements an der Aufnahme von einer in Steckrichtung hinteren Seite, durch die Vergussmasse, und von einer in Steckrichtung vorderen Seite, durch die Aufnahme und insbesondere deren Hohlkörper. Die gekapselte Anordnung des Koppelelements kann ferner insbesondere eine dreidimensionale des Koppelelements an der Aufnahme bilden, mit einer formschlüssigen und/oder stoffschlüssigen Befestigung von einer in Steckrichtung hinteren Seite, insbesondere durch die Vergussmasse, mit einer formschlüssigen und/oder stoffschlüssigen Befestigung von einer in Steckrichtung vorderen Seite, insbesondere durch die Aufnahme, optional durch die Aufnahme und die Vergussmasse, und mit einer formschlüssigen und/oder stoffschlüssigen Befestigung in Radialrichtung, insbesondere durch die Vergussmasse, optional durch die Aufnahme und die Vergussmasse.

Die Aufnahme ist insbesondere ausgebildet, das Koppelelement im Wesentlichen in Steckrichtung aufzunehmen. Mit anderen Worten ist die Aufnahme so ausgebildet, dass das Koppelelement in Steckrichtung an der Aufnahme anordenbar ist, beispielsweise formschlüssig und/oder reibschlüssig an der Aufnahme anordenbar ist. Beispielsweise ist das Koppelelement durch eine Öffnung in die Aufnahme führbar und an oder in der Aufnahme anordenbar, welche der selben Öffnung zum Befüllen der Vergussmasse entspricht, welche hierin auch als Befüllöffnung bezeichnet ist.

Die Befüllöffnung ist insbesondere eine andere Öffnung, als die Öffnung an oder in welcher das Koppelelement abschnittsweise anordenbar ist.

In bevorzugten Ausführungsformen ist das Koppelelement mit seinem in Steckrichtung rückwärtig in den Hohlraum der Aufnahme hineinragenden Teil haltbar, d.h. beispielsweise kann das Koppelelement während eines Befüllens des Hohlraums und/oder während eines abschnittsweisen Anordnens des Koppelelements an oder in der Öffnung zur Halterung des Koppelelements gehalten werden, z.B. manuell und/oder semi-manuell robotergestützt oder vollständig automatisch. Der in Steckrichtung rückwärtig in den Hohlraum der Aufnahme hineinragende Teil kann insbesondere durch ein Werkzeug, einen Bediener und/oder ein zum Halten geeignetes oder ausgebildetes Hilfsmittel haltbar sein.

In beispielhaften Ausführungsformen ist das Koppelelement mit seinem in Steckrichtung rückwärtig in den Hohlraum der Aufnahme hineinragenden Teil haltbar, während eines Schritt des Befüllens, oder mit anderen Worten Füllens, der Aufnahme mit der Vergussmasse, insbesondere während eines Befüllens des Hohlraums der Aufnahme mit der Vergussmasse.

Der Teil des Koppelelements, welcher in Steckrichtung rückwärtig in den Hohlraum der Aufnahme ragt, kann beispielsweise eine Leiterplatte, insbesondere eine PCB (printed circuit board), ein Kabel, und/oder einen männlichen und/oder weiblichen Anschluss, also einen männlichen Stecker und/oder eine weibliche Buchse, insbesondere einen männlichen und/oder einen weiblichen USB-C Anschluss, umfassen oder daraus bestehen.

Dadurch ist der in Steckrichtung rückwärtig in den Hohlraum ragende Teil des Koppelelements vorteilhaft einfach haltbar, wenn der Hohlraum mit der Vergussmasse befüllt ist bzw. wird. Insbesondere ist der in Steckrichtung rückwärtig in den Hohlraum ragende Teil des Koppelelements vorteilhaft einfach in eine vorbestimmte, anwendungsspezifische Richtung relativ zur Aufnahme und/oder zum Koppelgehäuse ausrichtbar, wenn der Hohlraum mit der Vergussmasse befüllt ist bzw. wird.

Der USB-C Anschluss des Koppelelements kann insbesondere ein männlicher USB-C Anschluss, also ein USB-C Stecker, oder ein weiblicher USB-C Anschluss, also eine USB-C Buchse, sein oder an einer Seite einen männlichen USB-C Anschluss, also einen USB-C Stecker aufweisen und an der anderen Seite einen weiblichen USB-C Anschluss, also eine USB-C Buchse aufweisen.

Der Hohlraum der Aufnahme ist insbesondere von dem Hohlkörper umgrenzt, insbesondere zumindest in Radialrichtung von dem Hohlkörper umgrenzt.

Der Hohlraum der Aufnahme ist insbesondere von einem in Steckrichtung vorderen Ende sich nach in Steckrichtung hinten öffnend ausgebildet. Mit anderen Worten ist der Hohlraum der Aufnahme insbesondere ausgebildet von der in Steckrichtung hinteren Seite, durch die Befüllöffnung der Aufnahme, befüllt zu werden, insbesondere derart, dass der Teil des Koppelelements, welcher in den Hohlraum ragt, zumindest abschnittsweise von der Vergussmasse umgeben ist bzw. wird, insbesondere in Umfangsrichtung vollständig von der Vergussmasse umgeben ist bzw. wird.

Die Öffnung der Aufnahme ist insbesondere ausgebildet zumindest teilweise durch das Koppelelement verschlossen zu sein, insbesondere derart verschlossen zu sein, dass sich die Vergussmasse bei einem Schritt des Befüllens des Hohlraums mit der Vergussmasse im Wesentlichen im Hohlraum der Aufnahme sammelt, insbesondere schon vor dem Erreichen eines ausgehärten Zustands der Vergussmasse im Wesentlichen im Hohlraum der Aufnahme sammelt.

Die Vergussmasse kann ein elektrisch im Wesentlichen nicht leitfähiges Material umfassen oder daraus bestehen.

Alternativ oder zusätzlich kann die Vergussmasse insbesondere ein gießfähiges, insbesondere spritzgießfähiges, härtbares Polymer umfassen oder daraus bestehen, beispielsweise einen gießfähigen, insbesondere spritzgießfähigen, härtbaren Thermoplasten, einen gießfähigen, insbesondere spritzgießfähigen, härtbaren Duroplasten, und/oder einen gießfähigen, insbesondere spritzgießfähiges, härtbaren Compound umfassen oder daraus bestehen.

Die Vergussmasse kann beispielsweise Polyester, Polyamid, Polycarbonat, Epoxid, und/oder Polysiloxan (Silikon) umfassen oder daraus bestehen. Alternativ oder zusätzlich kann die Vergussmasse einen Compound aus einem der vorstehend genannten Polymere und einem Füllstoff, insbesondere einen die Wärmeleitfähigkeit des Polymers steigernden Füllstoff, umfassen oder daraus bestehen. Ein die Wärmeleitfähigkeit steigernder Füllstoff kann beispielsweise Bornitrid umfassen oder daraus bestehen.

Die Vergussmasse kann beispielsweise ein Mehrkomponenten Polyurethan-Gießharz umfassen oder daraus bestehen, insbesondere ein 2-Komponenten Polyurethan-Gießharz umfassen oder daraus bestehen. Das Mehrkomponenten Polyurethan-Gießharz kann insbesondere lösemittelfrei und/oder frei von halogenierten Flammschutzmitteln sein. Das Mehrkomponenten Polyurethan-Gießharz kann insbesondere elektrisch isolierende Eigenschaften aufweisen, und/oder selbstlöschende Eigenschaften aufweisen. Das Mehrkomponenten Polyurethan-Gießharz kann ein Verhältnis zwischen Harz und Härter im Bereich von etwa 100 zu 10 bis etwa 100 zu 20, insbesondere von etwa 100 zu 14 Gewichtsteilen aufweisen.

Die Vergussmasse kann insbesondere eine Shore-Härte im Bereich von etwa D 40 bis etwa D 60, insbesondere von etwa D 45 bis etwa D 55 aufweisen, vorzugsweise bestimmt nach ISO 868 und/oder DIN 5305, vorzugsweise gültig zum vorliegenden Anmeldetag.

Die Vergussmasse kann insbesondere eine Wärmeleitfähigkeit im Bereich von etwa 0,4 bis etwa 0,8 W/(m·K), insbesondere von etwa 0,6 W/(m·K) aufweisen, vorzugsweise bestimmt nach DIN EN ISO 22077, vorzugsweise gültig zum vorliegenden Anmeldetag.

Die Vergussmasse kann insbesondere eine Glasübergangstemperatur im Bereich von etwa 5 °C bis etwa -8 °C, insbesondere von etwa -2 °C aufweisen, vorzugsweise bestimmt mittels Thermo-mechanischer Analyse (TMA).

Die Vergussmasse kann insbesondere einen thermischen Ausdehnungskoeffizienten unterhalb der Glasübergangstemperatur im Bereich von etwa 85 ppm/K bis etwa 110 ppm/K, insbesondere von etwa 97,5 ppm/K aufweisen, vorzugsweise bestimmt mittels Thermo-mechanischer Analyse (TMA).

Die Vergussmasse kann insbesondere einen thermischen Ausdehnungskoeffizienten oberhalb der Glasübergangstemperatur im Bereich von etwa 155 ppm/K bis etwa 180 ppm/K, insbesondere von etwa 167 ppm/K aufweisen, vorzugsweise bestimmt mittels Thermo-mechanischer Analyse (TMA).

Die Vergussmasse kann insbesondere eine Durchschlagfestigkeit im Bereich von etwa 25 kV/mm bis etwa 35 kV/mm, insbesondere von etwa 35 kV/mm aufweisen, vorzugsweise bestimmt nach IEC 60243-1, VDE 0303, TI.2, vorzugsweise gültig zum vorliegenden Anmeldetag.

Die Vergussmasse kann insbesondere einen spezifischen Durchgangswiderstand im Bereich von etwa 10¹³ Ω·cm bis etwa 10¹⁵ Ω·cm, insbesondere von etwa 10¹⁴ Ω·cm aufweisen, vorzugsweise bestimmt nach IEC 60243-1, VDE 0303, TI.30, vorzugsweise gültig zum vorliegenden Anmeldetag.

Die Vergussmasse kann insbesondere einen Oberflächenwiderstand im Bereich von etwa 10¹⁵ Ω bis etwa 10¹⁷ Ω, insbesondere von etwa 10¹⁶ Ω aufweisen, vorzugsweise bestimmt nach IEC 60243-1, VDE 0303, TI.30, vorzugsweise gültig zum vorliegenden Anmeldetag.

Die Vergussmasse kann insbesondere eine Dielektrizitätszahl bei 50 Hz und 23 °C von etwa 5.0 bis etwa 6.2, insbesondere von etwa 5.7 aufweisen, vorzugsweise bestimmt nach IEC 60250, VDE 0303, TI.4, vorzugsweise gültig zum vorliegenden Anmeldetag.

Die Vergussmasse kann insbesondere eine Dielektrizitätszahl bei 1 kHz und 23 °C von etwa 4.5 bis etwa 5.8, insbesondere von etwa 5.1 aufweisen, vorzugsweise bestimmt nach IEC 60250, VDE 0303, TI.4, vorzugsweise gültig zum vorliegenden Anmeldetag.

Die Vergussmasse kann insbesondere eine Dielektrizitätszahl bei 1 MHz und 23 °C von etwa 4.3 bis etwa 5.6, insbesondere von etwa 4.9 aufweisen, vorzugsweise bestimmt nach IEC 60250, VDE 0303, TI.4, vorzugsweise gültig zum vorliegenden Anmeldetag.

Die Vergussmasse kann insbesondere einen dielektrischen Verlustfaktor bei 1 MHz und 50 °C und 23 °C von etwa 0,05 bis etwa 0,13, insbesondere von etwa 0,09 aufweisen, vorzugsweise bestimmt nach IEC 60250, VDE 0303, TI.4, vorzugsweise gültig zum vorliegenden Anmeldetag.

Die Vergussmasse kann insbesondere Kriechstromfestigkeit nach CTI von etwa 550 bis etwa 650, insbesondere von etwa 600 aufweisen, vorzugsweise bestimmt nach IEC 60112, VDE 0303, TI.1, vorzugsweise gültig zum vorliegenden Anmeldetag.

Die Vergussmasse kann insbesondere eine Erweichungstemperatur, oder mit anderen Worten Glasübergangstemperatur insbesondere bei einer thermoplastischen Vergussmasse, aufweisen, welche geringer ist als eine Löttemperatur der Kontakte des Koppelelements. Die Erweichungstemperatur definiert eine Temperatur im Übergang zwischen einem flüssigen oder gummielastischen, flexiblen Zustand und einem glasartigen oder hartelastischen, spröden Zustand der Vergussmasse.

Dadurch kann vorteilhaft ein Lösen von Lötstellen beim Befüllen mit der Vergussmasse, während die Vergussmasse noch zumindest teilweise fließfähig ist, verhindert werden.

Das Koppelgehäuse ist insbesondere ausgebildet, die Aufnahme radial innerhalb des Koppelgehäuses zu halten. Mit anderen Worten ist das Koppelgehäuse insbesondere ausgebildet, die Aufnahme radial von außen zu umgeben.

Das Koppelgehäuse oder zumindest ein Teil des Koppelgehäuses kann insbesondere zumindest abschnittsweise einen Innenradius aufweisen, der größer ist als ein Außenradius der Aufnahme, insbesondere jedoch abgesehen von formschlüssigen Eingriffen und/oder Anschlägen zwischen der Aufnahme und des Koppelgehäuses, insbesondere in Steckrichtung.

Dadurch ist das Koppelelement vorteilhaft gezielt an der Aufnahme fixierbar. Ferner ist das Koppelelement insbesondere vorteilhaft mit einem vergleichsweise geringen Materialeinsatz bzw. einem geringen Volumen an Vergussmasse, an der Aufnahme fixierbar, insbesondere dicht fixierbar.

Die Aufnahme und insbesondere dessen Öffnung, an welcher das Koppelelement anordenbar ist, ist insbesondere so geformt oder ausgebildet, dass der USB-C Anschluss des Koppelelements in Steckrichtung nach vorne von der Öffnung der Aufnahme vorragt.

In beispielhaften Ausführungsformen kann der Hohlkörper so geformt oder ausgebildet sein, dass der Hohlkörper zumindest abschnittsweise den USB-C Anschluss, welcher von der Öffnung des Hohlkörpers vorragt, umgibt.

Die Öffnung kann insbesondere im Wesentlichen mittig, also in Radialrichtung im Wesentlichen mittig, an der Aufnahme angeordnet sein bzw. am Hohlkörper der Aufnahme angeordnet sein.

Der Hohlkörper kann insbesondere so geformt oder ausgebildet sein, dass er den von der Öffnung in Steckrichtung vorragenden USB-C Anschluss insbesondere vollständig in Umfangsrichtung umgibt, insbesondere zumindest abschnittsweise oder vollständig entlang der Erstreckung des USB-C Anschlusses in Steckrichtung.

Mit anderen Worten kann der Hohlkörper insbesondere so geformt sein, dass die Öffnung zur Aufnahme des Koppelelements gegenüber einem in Steckrichtung vorderen Ende des Hohlkörpers entgegen der Steckrichtung (also in Steckrichtung nach hinten) versetzt angeordnet ist.

Mit weiter anderen Worten kann der Hohlkörper an seiner in Steckrichtung vorderen Seite einen im Wesentlichen ringförmigen Vorsprung aufweisen, welcher sich in Steckrichtung weiter nach vorne erstreckt, als die Öffnung, wobei die Öffnung insbesondere im Wesentlichen mittig, also im Wesentlichen in Radialrichtung mittig in dem ringförmigen Vorsprung angeordnet ist.

Dadurch kann das Koppelement und insbesondere dessen USB-C Anschluss vorteilhaft durch den Hohlkörper geschützt sein bzw. werden, insbesondere berührgeschützt und/oder vor Staub oder Fremdkörpern bestimmter Größe geschützt sein bzw. werden.

In beispielhaften Ausführungsformen kann die Aufnahme ein Isolator sein, oder mit anderen Worten ein elektrisch isolierendes Material umfassen oder daraus bestehen. Alternativ kann der Isolator insbesondere ein metallisches Material umfassen oder daraus bestehen. Optional kann der Isolator eine elektrisch isolierenden Beschichtung aufweisen.

Dadurch ist das Koppelelement in der Aufnahme vorteilhaft insbesondere elektrisch geschützt anordenbar.

Die Aufnahme kann, ohne darauf beschränkt zu sein, insbesondere einstückig gebildet sein. Dadurch ist die Aufnahme vorteilhaft einfach herstellbar. In alternativen Ausführungsformen kann die Aufnahme beispielsweise mehrstückig gebildet sein, und beispielsweise zwei oder mehr Aufnahmeschalen umfassen, welche gemeinsam die Aufnahme bilden. Die zwei oder mehr Aufnahmeschalen kann zueinander fixierbar ausgebildet sein, insbesondere formschlüssig zueinander fixierbar ausgebildet sein, und/oder stoffschlüssig zueinander fixierbar sein, beispielsweise durch die Vergussmasse.

Die Aufnahme kann insbesondere formschlüssig und/oder reibschlüssig am oder im Koppelgehäuse gehalten sein, insbesondere in Steckrichtung formschlüssig am oder im Koppelgehäuse gehalten sein. Der Formschluss kann beispielsweise einen stirnseitigen Anschlag der Aufnahme in Steckrichtung und/oder entgegen der Steckrichtung umfassen. Alternativ oder zusätzlich kann die Aufnahme einen oder mehrere Vorsprünge und/oder Rücksprünge umfassen, welche mit komplementären Rücksprüngen und/oder Vorsprüngen des Koppelgehäuses in Eingriff sind.

Dadurch ist die Aufnahme nicht nur einfach, sondern insbesondere anwendungsspezifisch ausbildbar, und stellt eine vorteilhafte Vielzahl von Freiheitsgraden zur Anordnung des Koppelelements an der Aufnahme, und/oder zur Anordnung und insbesondere Festlegung der Aufnahme an dem Koppelgehäuse bereit.

Im Weiteren werden verschiedene Begriffe wiederholt verwendet, deren Verständnis durch die nachfolgenden Definitionen erleichtert werden soll.

Der gekoppelte Zustand des Steckverbindersystems beschreibt insbesondere einen Zustand, in dem der USB-C Anschluss eines USB-C Steckverbinders und der komplementäre USB-C Anschluss eines zum USB-C Steckverbinder komplementären USB-C Steckverbinders miteinander gekoppelt sind, insbesondere leitfähig miteinander gekoppelt sind, insbesondere elektrisch leitfähig und/oder datenübertragungsfähig miteinander gekoppelt sind.

In beispielhaften Ausführungsformen können das Koppelgehäuse des einen USB-C Steckverbinders und das Koppelgehäuse des komplementären USB-C Steckverbinders im gekoppelten Zustand zusätzlich oder alternativ reibschlüssig und/oder formschlüssig miteinander gekoppelt sein. Im gekoppelten Zustand des Steckverbindersystems können sich der USB-C Steckverbinder und der komplementäre USB-C Steckverbinder insbesondere zumindest abschnittsweise (gegenseitig) berühren, insbesondere mit einer Vorspannung (gegenseitig) berühren. Weiter zusätzlich oder alternativ können der USB-C Steckverbinder und der komplementäre USB-C Steckverbinder im gekoppelten Zustand dicht miteinander gekoppelt sein, insbesondere wasserdicht miteinander gekoppelt sein.

Der entkoppelte Zustand des Steckverbindersystems, der vorliegend auch als nichtgekoppelter Zustand beschrieben ist, beschreibt insbesondere einen Zustand, in dem der USB-C Steckverbinder und der komplementäre USB-C Steckverbinder nicht miteinander gekoppelt sind, insbesondere nicht leitfähig, und/oder formschlüssig und/oder reibschlüssig miteinander gekoppelt sind.

In beispielhaften Ausführungsformen können der USB-C Steckverbinder und der komplementäre USB-C Steckverbinder im entkoppelten Zustand weder formschlüssig, noch reibschlüssig und/oder stoffschlüssig miteinander gekoppelt sein. Im entkoppelten Zustand des Steckverbindersystems berühren sich der USB-C Steckverbinder und der komplementäre USB-C Steckverbinder insbesondere nicht, oder berühren sich ohne eine (gegenseitige) Vorspannung.

In einem beispielhaften entkoppelten Zustand können der USB-C Steckverbinder und der komplementäre USB-C Steckverbinder in Steckrichtung einander gegenüberliegen bzw. einander gegenüberliegend angeordnet sein.

Steckverbinder bzw. Rundsteckverbinder: Der Rundsteckverbinder stellt vorliegend im Wesentlichen einen Steckverbinder dar, welcher zumindest abschnittsweise eine im Wesentlichen zylindrische oder rohrförmige Form oder Kontur aufweisen, ist darauf jedoch nicht beschränkt, und kann im Querschnitt zu einer Axialrichtung oder Steckrichtung des Rundsteckverbinders auch beliebig konturiert sein, insbesondere vieleckig sein oder abschnittsweise rund und eckig sein. Der Rundsteckverbinder kann insbesondere mittels seines Koppelgehäuses eine Schraubverbindung und/oder eine push-push Verbindung und/oder eine push-pull Verbindung zu einem komplementären Rundsteckverbinder bereitstellen oder mit einem komplementären Rundsteckverbinder bilden.

Axialrichtung: Die Axialrichtung beschreibt insbesondere eine Richtung, in welcher der Rundsteckverbinder seine größte Erstreckung aufweist. Die Axialrichtung kann darüber hinaus insbesondere im Wesentlichen in einer Richtung liegen, entlang der die USB-C Anschlüsse konfiguriert sind, angeschlossen oder kontaktiert zu werden. Somit kann die Axialrichtung insbesondere im Wesentlichen einer Steckrichtung des Rundsteckverbinders entsprechen. Die Steckrichtung stellt dabei die Richtung dar, in der der Rundsteckverbinder relativ zu einem komplementären Rundsteckverbinder bewegt wird, um einen elektrisch leitfähigen und/oder datenübertragungsfähigen Kontakt zwischen dem Rundsteckverbinder und einem komplementären Rundsteckverbinder bereitzustellen.

Umfangsrichtung: Die Umfangsrichtung stellt eine Richtung dar, welche im Wesentlichen senkrecht zur Axialrichtung oder Steckrichtung ist. Die Umfangsrichtung kann insbesondere im Wesentlichen einer Richtung entlang eines Umfangs des Steckverbinders und insbesondere Rundsteckverbinders oder einer Richtung entlang einer Außenkontur des Steckverbinders bzw. Rundsteckverbinders in einem Querschnitt des Steckverbinders bzw. Rundsteckverbinders entsprechen, oder einer Richtung entlang der Außenkontur eines Elements des Steckverbinders bzw. Rundsteckverbinders in einem Querschnitt des Steckverbinders bzw. Rundsteckverbinders entsprechen, wobei der Querschnitt im Wesentlichen senkrecht zur Axialrichtung oder Steckrichtung des Steckverbinders bzw. Rundsteckverbinders verläuft. Dabei kann die Umfangsrichtung insbesondere einer Richtung entlang einer Tangente an einen Umfang des Steckverbinders bzw. Rundsteckverbinders oder eines Elements des Steckverbinders bzw. Rundsteckverbinders entsprechen, insbesondere einer Richtung entlang einer Tangente an eine Kontur des Steckverbinders bzw. Rundsteckverbinders oder eines Elements des Steckverbinders bzw. Rundsteckverbinders in einem Querschnitt entsprechen. Die Umfangsrichtung kann mit anderen Worten insbesondere ähnlich zu einer Umfangsrichtung eines Zylinders sein, wobei der vorliegende Steckverbinders und insbesondere Rundsteckverbinder nicht auf eine streng zylinderförmige Kontur beschränkt ist.

Radialrichtung: Die Radialrichtung stellt eine Richtung dar, welche im Wesentlichen senkrecht zur Axialrichtung oder Steckrichtung und/oder der Umfangsrichtung ist. Die Radialrichtung kann insbesondere von einer Achse des Steckverbinders und insbesondere Rundsteckverbinders hin zu einer Außenkontur oder Mantelfläche zeigen, insbesondere hin zu einer Außenkontur oder Mantelfläche des Steckverbinders bzw. Rundsteckverbinders oder eines Elements des Steckverbinders bzw. Rundsteckverbinders.

Die Axialrichtung oder Steckrichtung kann zusammen mit der Umfangsrichtung und der Radialrichtung insbesondere ein Rechtshandsystem bilden, insbesondere ein Zylinderkoordinatensystem.

Steckrichtung: Die Steckrichtung beschreibt insbesondere eine Richtung, in welcher der Steckverbinder und der komplementäre Steckverbinder, und insbesondere deren Koppelgehäuse und/oder deren USB-C Anschlüsse relativ zueinander bewegbar sind bzw. zu bewegen sind, um in den gekoppelten Zustand und/oder in den entkoppelten Zustand überführt zu werden.

Die Steckrichtung des Steckverbinders und insbesondere Rundsteckverbinders kann im Wesentlichen parallel zur Steckrichtung des komplementären Steckverbinders und insbesondere Rundsteckverbinders sein. Die Steckrichtung des Steckverbinders kann zusätzlich oder alternativ eine zur Steckrichtung des komplementären Steckverbinders im Wesentlichen entgegengesetzte Richtung sein.

Es versteht sich, dass die Steckrichtung bei der Montage durch einen Bediener und/oder eine Bedieneinheit von der hier definierten Steckrichtung abweichen kann, solange sie zu einer Kopplung, insbesondere beschädigungsfreien Kopplung, des Steckverbinders mit dem komplementären Steckverbinder führt.

Die Höhenrichtung beschreibt insbesondere eine Richtung, in welcher der USB-Anschluss üblicherweise als flach bezeichnet wird.

Die Breitenrichtung kann insbesondere einer Haupterstreckungsrichtung des USB-Anschlusses entsprechen, welche insbesondere senkrecht zur Steckrichtung des USB-Anschlusses ist. Die Breitenrichtung kann insbesondere im Wesentlichen einer Richtung entsprechen, in welcher eine Mehrzahl von Kontakten und/oder Leiterelementen des USB-Koppelelements nebeneinanderliegend angeordnet sind, beispielsweise, um mit Kontakten bzw. Leiterelementen einer Leiterplatte, insbesondere PCB, leitfähig in Kontakt zu gelangen. Die Breitenrichtung kann insbesondere im Wesentlichen senkrecht oder senkrecht zur Höhenrichtung sein.

Die Steckrichtung kann im Wesentlichen parallel zur Axialrichtung sein. Alternativ oder zusätzlich kann die Steckrichtung im Wesentlichen senkrecht zur Breitenrichtung und/oder zur Höhenrichtung sein.

Der Schutz wie hierin erwähnt kann insbesondere ein Berührschutz sein. Der Berührschutz kann insbesondere einen Schutz gegen ein Berühren durch einen Bediener umfassen, beispielsweise gegen ein Berühren durch einen Finger des Bedieners. Alternativ oder zusätzlich kann der Berührschutz einen Schutz gegen ein Berühren mit Objekten vorbestimmter Größe umfassen, beispielsweise gegen ein Berühren mit Objekten, welche in ihrer kleinsten Erstreckungsrichtung ein Abmaß von mehr als etwa 18 mm umfassen, insbesondere von mehr als etwa 15 mm umfassen. Der Schutz kann beispielsweise durch eine vorbestimmte Definition einer oder mehrerer am Koppelgehäuse und/oder an der Aufnahme ausgebildeten Öffnungen bereitgestellt sein oder werden.

Ist vorliegend von einer Schutzart oder von einem Schutz nach einer IP Klasse die Rede, ist darunter insbesondere eine Schutzart gemäß der Norm DIN EN 60529 (VDE 0470) zu verstehen, insbesondere gemäß der Norm DIN EN 60529:2014-09 vom September 2014.

Wird eine Richtung oder ein Winkel mit dem Zusatz "im Wesentlichen" oder "in etwa" oder "etwa" wiedergegeben, so sei mit diesem Zusatz insbesondere eine Abweichung von der betreffenden Richtung oder vom betreffenden Winkel im Bereich von 0° bis 5° gemeint oder zu verstehen.

Wird ein räumliches Maß, ein räumliches Verhältnis oder ein sonstiges Verhältnis mit dem Zusatz "im Wesentlichen" oder "in etwa" oder "etwa" wiedergegeben, so sei mit diesem Zusatz insbesondere eine Abweichung von dem betreffenden Maß oder dem betreffenden Verhältnis im Bereich von 0 % bis 10 % gemeint oder zu verstehen.

In bevorzugten Ausführungsformen der USB-C Koppelvorrichtung kann die Aufnahme an einer radial äußeren Seite eine Nut aufweisen, welche sich zumindest abschnittsweise im Wesentlichen in Umfangsrichtung erstreckt. Mit anderen Worten kann die Aufnahme insbesondere an einer Außenumfangsseite eine Nut aufweisen, welche sich zumindest abschnittsweise im Wesentlichen in Umfangsrichtung erstreckt.

Mittels der Nut ist an der Aufnahme vorteilhaft ein Dichtelement, beispielsweise ein (gummi-)elastischer Dichtring, insbesondere ein O-Ring, an der Aufnahme sicher vormontierbar. Dadurch kann im Weiteren vorteilhaft eine Herstellung der Koppelvorrichtung, sowie eines damit gebildeten Steckverbinders, vereinfacht werden. Ferner kann vorteilhaft sichergestellt werden, dass das Dichtelement in einem vorbestimmten Bereich relativ zur Aufnahme festgelegt ist bzw. bleibt, beispielsweise bei einem Einführen der Aufnahme in das Koppelgehäuse.

Ferner ermöglicht die Nut vorteilhaft einen vorbestimmten formschlüssigen Eingriff mit dem Koppelgehäuse, beispielsweise indem das Koppelgehäuse mit der Aufnahme im Bereich der Nut in Eingriff ist bzw. gelangt.

In beispielhaften Ausführungsformen kann die Aufnahme an ihrer radial äußeren Seite oder mit anderen Worten an ihrer Außenumfangsseite, zwei im Wesentlichen in Steckrichtung zueinander beabstandete Vorsprünge aufweisen, welche im Wesentlichen in Radialrichtung von der Aufnahme vorspringen. Durch die Beabstandung der beiden Vorsprünge kann insbesondere die Nut gebildet sein, wie zuvor beschrieben.

Zumindest einer der beiden Vorsprünge oder einer oder mehrere weitere Vorsprünge, welche sich insbesondere im Wesentlichen in Radialrichtung von der Aufnahme erstrecken bzw. davon vorspringen, können alternativ oder zusätzlich einen formschlüssigen Eingriff und/oder einen Anschlag mit dem Koppelgehäuse bilden. Der Eingriff und/oder Anschlag ist insbesondere ausgebildet eine Relativbewegung der Aufnahme relativ zum Koppelgehäuse in Steckrichtung und/oder entgegen der Steckrichtung zu blockieren.

Dadurch ist die Aufnahme vorteilhaft genau am Koppelgehäuse haltbar, insbesondere formschlüssig haltbar.

In bevorzugten Ausführungsformen der USB-C Koppelvorrichtung kann die Aufnahme rückstellfähig am Koppelgehäuse angeordnet sein.

Beispielsweise kann ein rückstellfähiges, insbesondere elastisch rückstellfähiges Element zwischen dem Koppelgehäuse und der Aufnahme angeordnet sein. Mit anderen Worten kann die USB-C Koppelvorrichtung in beispielhaften Ausführungsformen ein rückstellfähiges Element, insbesondere elastisch rückstellfähiges Element, umfassen, welches zwischen dem Koppelgehäuse und der Aufnahme angeordnet ist, beispielsweise an oder in der Nut der Aufnahme angeordnet ist.

Die Aufnahme kann mittels des rückstellfähigen Elements insbesondere vorgespannt an dem Koppelgehäuse angeordnet, oder mit anderen Worten gehalten, sein. Die Vorspannung kann insbesondere eine Vorspannung in Steckrichtung und/oder in Radialrichtung umfassen.

In beispielhaften Ausführungsformen kann die Aufnahme formschlüssig, mit einem Spiel relativ zum Koppelgehäuse, an dem Koppelgehäuse gehalten oder angeordnet sein. Das Spiel kann dabei insbesondere ein Spiel in Radialrichtung und/oder in Axialrichtung umfassen, wobei die Axialrichtung insbesondere im Wesentlichen parallel zur Steckrichtung sein kann.

Mittels des rückstellfähigen, insbesondere elastisch rückstellfähigen Elements ist die Aufnahme vorteilhaft rückstellfähig, insbesondere festgelegt durch einen formschlüssigen Rahmen des Spiels zwischen Koppelgehäuse und Aufnahme, auslenkbar an dem Koppelgehäuse angeordnet bzw. anordenbar. Insbesondere wird ein Stecken bzw. eine Kopplung an den USB-C Anschluss ermöglicht, welches nicht auf ein exaktes Führen zweier komplementärer USB-C Anschlüsse in Steckrichtung beschränkt ist, sondern vielmehr ein Kompensieren von Fehlausrichtungen beim Stecken bzw. bei der Kopplung ermöglicht.

Das Koppelgehäuse und ein komplementäres Koppelgehäuse können insbesondere derart zueinander ausgebildet sein, dass in einem gekoppelten Zustand des Koppelgehäuses mit dem komplementären Koppelgehäuse eine mögliche rückstellfähige Auslenkung der Aufnahme beim Koppeln des USB-C Anschlusses mit einem komplementären USB-C Anschluss zurückgestellt ist, insbesondere vollständig zurückgestellt ist.

Das rückstellfähige, insbesondere elastisch rückstellfähige Element kann beispielsweise einen oder mehrere Sprengringe, eine oder mehrere Federn, insbesondere eine oder mehrere Zug- oder Druckfedern, eine oder mehrere gummielastische Ringe, insbesondere einen oder mehrere Dichtringe, wie beispielsweise O-Ringe, umfassen oder daraus bestehen.

Dadurch ist die Aufnahme sowie der USB-C Anschluss des Koppelelements vorteilhaft rückstellfähig, insbesondere elastisch rückstellfähig, sowie insbesondere vorteilhaft dicht, an dem Koppelgehäuse anordenbar. Dies ermöglicht ein flexibles Stecken bzw. Koppeln in Steckrichtung, wobei die genaue Ausrichtung des USB-C Anschlusses an der USB-C Koppelvorrichtung an eine Ausrichtung eines komplementären USB-C Anschlusses einer komplementären USB-C Koppelvorrichtung anpassbar ist, insbesondere beschädigungsfrei oder zerstörungsfrei anpassbar ist.

Somit kann vorteilhaft eine verbesserte, und insbesondere sowohl geschützte als auch vereinfachte Montage bzw. Kopplung, sichergestellt werden.

In bevorzugten Ausführungsformen der USB-C Koppelvorrichtung kann das USB-C Koppelelement zumindest abschnittsweise mit einem Spiel in der Öffnung der Aufnahme anordenbar sein. Mit anderen Worten kann die Öffnung insbesondere so geformt oder ausgebildet sein, dass sie abschnittsweise gegenüber dem USB-C Koppelelement ein Spiel, also eine Beabstandung, aufweist.

Dadurch kann beim Befüllen mit der Vergussmasse vorteilhaft ein Teil der Vergussmasse zwischen einen Abschnitt des USB-C Koppelements und der Öffnung fließen oder mit anderen Worten gelangen, und insbesondere vorteilhaft diejenigen Abschnitte zwischen dem USB-C Koppelelement und der Öffnung abdichten, welche durch die abschnittsweise Anordnung des USB-Koppelelements an der Öffnung nicht staub- und/oder wasserdicht sind.

Die Öffnung kann insbesondere im Wesentlichen schlitzförmig oder mit anderen Worten flach ausgebildet sein, also insbesondere mit einer Erstreckung, welche in Breitenrichtung größer ist, als in einer Höhenrichtung. Die Höhenrichtung entspricht dabei einer Richtung, in welcher der Fachmann einen USB-C Anschluss als flach bezeichnet. Die Breitenrichtung ist insbesondere im Wesentlichen senkrecht zur Höhenrichtung.

In beispielhaften Ausführungsformen kann die Öffnung so geformt oder ausgebildet sein, dass sie im Wesentlichen in Breitenrichtung der Öffnung ein Spiel gegenüber des USB-C Koppelelements aufweist.

Zusätzlich oder alternativ kann die Öffnung so geformt oder ausgebildet sein, dass sie im Wesentlichen in Höhenrichtung der Öffnung kein Spiel gegenüber dem USB-C Koppelelement aufweist, oder zumindest kein Spiel gegenüber dem USB-C Koppelelement aufweist, welches ein Fließen oder Gelangen der Vergussmasse dorthinein ermöglicht.

Dadurch ist das Koppelelement vorteilhaft fest und/oder dicht an oder in der Aufnahme fixierbar, während weiter vorteilhaft insbesondere ein Verkanten entlang der Höhenrichtung, beispielsweise durch eindringende Vergussmasse, vorteilhaft erschwert oder verhindert wird.

Die Öffnung der Aufnahme kann eine im Wesentlichen ovale Form aufweisen, insbesondere in einem Querschnitt quer zur Steckrichtung des in der Öffnung teilweise anordenbaren USB-C Koppelelements.

Die ovale Form der Öffnung kann insbesondere derart ausgebildet sein, dass die Öffnung gegenüber einem Standard USB-C Koppelelement in einer langen Richtung der ovalen Form, ein Spiel zum USB-C Koppelelement aufweist, und dass die Öffnung gegenüber einem Standard USB-C Koppelelement in einer kurzen Richtung der ovalen Form, kein Spiel zum USB-C Koppelelement aufweist.

Die kurze und die lange Richtung der ovalen Form sind insbesondere im Wesentlichen senkrecht zueinander.

Das USB-C Koppelelement ist insbesondere formschlüssig in oder an der Öffnung des Hohlkörpers der Aufnahme anordenbar, insbesondere derart formschlüssig, dass die Öffnung in einem angeordneten Zustand des USB-C Koppelelements in oder an der Öffnung eine Bewegung des USB-C Koppelelements in Steckrichtung nach vorne blockiert.

Die Öffnung der Aufnahme bzw. die Öffnung des Hohlkörpers der Aufnahme kann beispielsweise zumindest abschnittsweise stufenförmig und/oder trichterförmig entlang der Steckrichtung ausgebildet sein, insbesondere derart, dass sich ein Querschnitt der Öffnung, oder mit anderen Worten eine Fläche des Querschnitts der Öffnung, in Steckrichtung verkleinert.

Dadurch ist das Koppelelement vorteilhaft einfach an oder in der Öffnung montierbar, insbesondere in Steckrichtung an oder in der Öffnung montierbar. So kann ein Bediener und/oder eine Bedieneinrichtung das Koppelelement beispielsweise in Steckrichtung in die Aufnahme stecken bzw. einführen bis es nicht weiter geht, die einem weiteren Einführen entgegenstehende Reibungskraft zu hoch ist, oder ein bestimmter Anschlag erreicht ist.

In bevorzugten Ausführungsformen kann das Spiel der Öffnung relativ zum USB-C Koppelelement ausschließlich an einer in Steckrichtung hinteren Seite der Öffnung ausgebildet sein.

Dadurch ist das Koppelelement vorteilhaft einfach an oder in der Öffnung fixierbar, insbesondere während vorteilhaft eine Beeinträchtigung eines Koppelns mit dem USB-C Anschluss an der in Steckrichtung vorderen Seite der Öffnung, beispielsweise durch ausgehärtete Vergussmasse im Steckbereich für den komplementären Anschluss, vorteilhaft erschwert oder verhindert wird.

Ferner ist die Korrektheit der Anordnung des Koppelelements an oder in der Öffnung vorteilhaft passiv, insbesondere bereits während der Herstellung eines USB-C Steckverbinders auf Basis der USB-C Koppelvorrichtung, auf einfache Weise prüfbar. Beispielsweise kann ein Hindurchtropfen der Vergussmasse an der in Steckrichtung vorderen Seite der Öffnung, beim Befüllen des Hohlkörpers von der in Steckrichtung hinteren Seite der Öffnung, passiv eine fehlerhafte Anordnung des Koppelelements in der Öffnung anzeigen.

Dies ermöglicht vorteilhaft entsprechende Gegenmaßnahmen zu ergreifen, beispielsweise zur Korrektur und/oder zum zumindest einstweiligen Stopp des weiteren Herstellungsverfahrens, und ermöglicht ferner passiv, insbesondere ohne weitere Qualitätsprüfung, ein Ausschussteil zu definieren.

In bevorzugten Ausführungsformen der USB-C Koppelvorrichtung kann das USB-C Koppelelement berührgeschützt in dem Koppelgehäuse anordenbar sein,
und es kann das USB-C Koppelelement insbesondere nach der Schutzart IP 50 an der Koppelvorrichtung anordenbar sein.

Insbesondere kann der USB-C Anschluss berührgeschützt, und insbesondere mit einem Schutz nach der Schutzart IP 50, in dem Koppelgehäuse anordenbar sein, und/oder der in Steckrichtung rückwärtig in den Hohlraum ragende Teil des USB-C Koppelelements berührgeschützt, und insbesondere mit einem Schutz nach der Schutzart IP 50, in dem Koppelgehäuse anordenbar sein.

Mit anderen Worten kann die USB-C Koppelvorrichtung insbesondere ausgebildet sein, einen Berührschutz, insbesondere einen Schutz nach der Schutzart IP 50, für das Koppelelement zu bilden.

In beispielhaften Ausführungsformen kann das USB-C Koppelelement mittels des Koppelgehäuses und/oder mittels der Aufnahme berührgeschützt an oder in zumindest dem Koppelgehäuse bzw. der Aufnahme angeordnet sein. Mit anderen Worten kann zumindest eines von dem Koppelgehäuse und der Aufnahme einen Berührschutz, und insbesondere einen Schutz nach der Schutzart IP 50, für das USB-C Koppelelement bilden oder mit anderen Worten bereitstellen.

Beispielsweise kann in einem Zustand, in dem das USB-C Koppelelement an oder in der Öffnung des Hohlkörpers der Aufnahme angeordnet ist, die Aufnahme und/oder das Koppelgehäuse sich derart erstrecken, dass das USB-C Koppelelement in Umfangsrichtung umgeben ist, und/oder derart erstrecken, dass es in Steckrichtung zumindest genauso weit oder weiter erstreckt, als das USB-C Koppelelement. Dies gilt insbesondere für den USB-C Anschluss in Steckrichtung nach vorne, und alternativ oder zusätzlich für den in Steckrichtung rückwärtig in den Hohlraum ragenden Teil des USB-C Koppelelements.

Dadurch ist das USB-C Koppelelement vorteilhaft beispielsweise bereits bei einer Montage der Aufnahme an dem Koppelgehäuse geschützt.

Ferner ist das USB-C Koppelelement insbesondere beim Handling und während einer Kopplung mit einer komplementären USB-C Koppelvorrichtung bzw. einem komplementären USB-C Steckverbinder vorteilhaft geschützt und insbesondere langlebig ausgebildet.

Im gekoppelten Zustand der USB-C Koppelvorrichtung mit einer komplementären USB-C Koppelvorrichtung bzw. des USB-C Steckverbinders mit einem komplementären USB-C Steckverbinder können die Koppelvorrichtungen bzw. die Steckverbinder insbesondere einen Schutz nach der Schutzart IP 68 bereitstellen oder bilden.

Dadurch sind die Koppelelemente zudem insbesondere vorteilhaft wasserdicht geschützt, und es ist eine vielseitige und langlebige elektrisch leitfähige sowie datenübertragungsfähige Verbindung bereitstellbar.

In bevorzugten Ausführungsformen der USB-C Koppelvorrichtung kann das USB-C Koppelelement eine weibliche USB-C Buchse oder einen männlichen USB-C Stecker an einer in Steckrichtung vorderen Seite aufweisen, und/oder
zumindest eines von einer Leiterplatte, einer weiblichen USB-C Buchse, einem männlichen USB-C Stecker, und einem Kabel, beispielsweise Daten- und/oder Stromkabel, an einer in Steckrichtung hinteren Seite aufweisen.

Die USB-C Buchse und der USB-C Stecker bilden jeweils einen USB-C Anschluss zur Kopplung, insbesondere elektrisch leitfähigen und/oder datenübertragungsfähigen Kopplung, mit einem jeweils komplementären USB-C Anschluss, also jeweils mit einem USB-C Stecker und einer USB-C Buchse.

Durch den USB-C Anschluss an der in Steckrichtung vorderen Seite des USB-C Koppelelements kann vorteilhaft eine sichere elektrisch leitfähige sowie datenübertragungsfähige Verbindung bereitgestellt werden, welche vorteilhaft bereits eine interne Schirmung aufweist. Dadurch kann vorteilhaft die USB-C Koppelvorrichtung vorteilhaft einfach ausgebildet oder hergestellt werden, insbesondere ohne eine weitere Schirmung, abgesehen von der des USB-C Anschlusses des anordenbaren USB-C Koppelelements.

Der USB-C Anschluss oder das Kabel an der in Steckrichtung hinteren Seite des USB-C Koppelelements ermöglichen vorteilhaft eine sichere elektrisch leitfähige sowie datenübertragungsfähige weiterleitende Verbindung bereitzustellen. Ferner ist der in Steckrichtung hintere Teil des USB-C Koppelelements insbesondere einfach in einer vorbestimmten Richtung haltbar beim Befüllen des Hohlraums des Hohlkörpers mit der Vergussmasse.

In bevorzugten Ausführungsformen der USB-C Koppelvorrichtung kann das Koppelgehäuse schalenförmig, mit mehreren Schalen entlang der Radialrichtung, ausgebildet sein, und es kann die Aufnahme relativ zur radial äußersten Schale des Koppelgehäuses drehbar gelagert sein.

Mit anderen Worten kann das Koppelgehäuse derart schalenförmig, mit mehreren Schalen entlang der radialen Richtung, ausgebildet sein und die Aufnahme halten, dass zwischen der Aufnahme und der radial äußersten Schale eine Drehmomentunterbrechung oder zumindest Drehmomentabschwächung angeordnet oder ausgebildet ist.

Beispielsweise kann eine Schale, welche im Wesentlichen in Radialrichtung zwischen der Aufnahme und der radial äußersten Schale angeordnet ist, relativ zur radial äußersten Schale drehbar, also insbesondere im Wesentlichen um eine Axialrichtung des Koppelgehäuses drehbar, angeordnet oder gelagert sein.

Dadurch ist vorteilhaft ein außen Drehmoment an der radial äußersten Schale des Koppelgehäuses anbringbar, beispielsweise zum Koppeln mit einem komplementären Koppelgehäuse, ohne das gleiche Drehmoment, also insbesondere ein demgegenüber verringertes Drehmoment oder vorzugsweise kein Drehmoment an die Aufnahme und das darin anordenbare Koppelelement zu übertragen.

Dadurch ist das USB-C Koppelelement vorteilhaft langlebig zur Bereitstellung einer elektrisch leitfähigen und/oder datenübertragungsfähigen an der USB-C Koppelvorrichtung anordenbar.

Das Koppelgehäuse kann insbesondere rohrförmig sein. Das Koppelgehäuse kann insbesondere mehrere Schalen aufweisen, welche im Wesentlichen in Radialrichtung des Koppelgehäuses aneinander angrenzen. Die Schalen können jeweils einstückig oder mehrstückig, beispielsweise als Halbschalen ausgebildet sein. Eine oder mehrere Schalen können im Wesentlichen in Axialrichtung und/oder im Wesentlichen in Umfangsrichtung bewegbar an dem Koppelgehäuse angeordnet sein. Zwischen zwei benachbarten Schalen, und/oder an einer Außenumfangsseite der in Radialrichtung äußersten Schale, und/oder an einer Innenumfangsseite der in Radialrichtung innersten Schale können eines oder mehrere Dichtelemente, beispielsweise O-Ringe angeordnet sein.

Dadurch ist die USB-C Koppelvorrichtung vorteilhaft einfach herstellbar, beispielsweise durch ein sequentielles Stecken der Schalen des Koppelgehäuses ineinander, während die einzelnen Schalen oder mehrere Schalen in Kombination vorteilhaft eine vorbestimmte Funktion bereitstellen, wie beispielsweise eine Push-Pull Koppelbarkeit, eine Dichtheit, eine Fixierung der Aufnahme, eine Fixierung einer Zugentlastung an einem Kabel, und/oder anderes.

In bevorzugten Ausführungsformen der USB-C Koppelvorrichtung kann das Koppelgehäuse eine Push-Pull Funktion bereitstellen.

In beispielhaften Ausführungsformen kann das Koppelgehäuse ein Betätigungselement umfassen, welches insbesondere in Steckrichtung verschiebbar angeordnet ist, wobei die Verschiebbarkeit vorzugsweise einen in Steckrichtung vorderen und einen in Steckrichtung hinteren Anschlag aufweist. Das Betätigungselement kann insbesondere als Betätigungsschale ausgebildet sein. Das Betätigungselement kann insbesondere einen konturierten Greifabschnitt aufweisen. Der konturierte Greifabschnitt stellt insbesondere einen haptisch vom restlichen Betätigungselement unterscheidbaren Abschnitt dar, und weist beispielsweise eine Randrierung und/oder eine Riffelung auf.

Alternativ oder zusätzlich kann das Koppelgehäuse einen Kopplungsabschnitt umfassen, welcher insbesondere einen oder mehrere Vorsprünge, insbesondere angeschrägte Vorsprünge aufweist, um mit einem komplementären Kopplungsabschnitt eines komplementären Koppelgehäuses in Eingriff zu gelangen, insbesondere formschlüssig in Eingriff zu gelangen. Der Kopplungsabschnitt kann insbesondere im Wesentlichen als Kopplungsschale ausgebildet sein, welche insbesondere einen oder mehrere sich im Wesentlichen in Axialrichtung oder Steckrichtung erstreckende Zinken aufweist. Die Zinken können jeweils rückstellfähig, insbesondere elastisch rückstellfähig ausgebildet sein, und insbesondere jeweils zumindest einen Vorsprung aufweisen. Der zumindest eine Vorsprung kann sich insbesondere im Wesentlichen in Radialrichtung von dem Zinken erstrecken kann, beispielsweise in Radialrichtung einwärts oder in Radialrichtung auswärts, insbesondere um mit dem komplementären Kopplungsabschnitt des komplementären Kopplungsgehäuses in Eingriff bringbar zu sein.

In bevorzugten Ausführungsformen ist das Betätigungselement relativ zum Kopplungsabschnitt bewegbar, insbesondere translatorisch verschiebbar ausgebildet. Insbesondere sind das Betätigungselement und der Koppelabschnitt so zueinander angeordnet, dass eine Bewegung des Betätigungselement, insbesondere entgegen der Axialrichtung oder entgegen der Steckrichtung, eine rückstellfähige Verformung des Kopplungsabschnitts und insbesondere dessen Zinken bewirkt, so dass ein formschlüssiger Eingriff zwischen dem Kopplungsabschnitt und dem komplementären Kopplungsabschnitt gelöst ist. Beispielsweise kann das Betätigungselement zumindest abschnittsweise radial um den Kopplungsabschnitt angeordnet sein, insbesondere wenn die Zinken radial nach außen gerichtete Vorsprünge aufweisen, oder zumindest abschnittsweise radial innerhalb des Kopplungsabschnitts angeordnet sein, insbesondere wenn die Zinken radial nach innen gerichtete Vorsprünge aufweisen.

Dadurch wird vorteilhaft eine sowohl einfache, als auch sichere und insbesondere dichte Kopplung mit einem komplementären Koppelgehäuse ermöglicht, welche insbesondere erst durch Betätigung des Betätigungselements lösbar ist, insbesondere beschädigungsfrei oder zerstörungsfrei lösbar ist.

Ein weiterer Aspekt der vorliegenden Erfindung betrifft einen USB-C Steckverbinder, insbesondere Rundsteckverbinder, umfassend:
- ein Koppelgehäuse;
- eine Aufnahme, welche an oder in einem vorderen Abschnitt des Koppelgehäuses, insbesondere radial innerhalb des Koppelgehäuses, gehalten ist, und
- ein USB-C Koppelelement, welches einen USB-C Anschluss aufweist;
   -- wobei die Aufnahme einen Hohlkörper mit einer Öffnung in Steckrichtung des USB-C Steckverbinders aufweist,
   -- wobei das USB-C Koppelelement abschnittsweise an oder in der Öffnung des Hohlkörpers angeordnet ist, derart, dass das USB-C Koppelelement zumindest teilweise in einen Hohlraum des Hohlkörpers ragt, und
   -- wobei der Hohlkörper zumindest abschnittsweise mit einer Vergussmasse befüllt ist.

Das USB-C Koppelelement ist insbesondere derart an oder in der Öffnung des Hohlkörpers angeordnet, dass ein in Steckrichtung hinterer Teil des USB-C Koppelelements in den Hohlraum ragt, und ein Steckrichtung vorderer Teil des USB-C Koppelelements, welcher insbesondere den USB-C Anschluss umfasst, in Steckrichtung von der Öffnung vorragt.

Der Hohlkörper bzw. der Hohlraum des Hohlkörpers ist insbesondere derart mit der Vergussmasse befüllt, dass das USB-C Koppelelement an der Aufnahme fixiert ist, insbesondere stoffschlüssig an der Aufnahme fixiert ist oder mit anderen Worten stoffschlüssig mit der Aufnahme verbunden ist.

Der Hohlkörper bzw. dessen Hohlraum können insbesondere derart mit der Vergussmasse befüllt sein, dass zumindest der in den Hohlraum ragende Teil des USB-C Koppelelements zumindest teilweise von der Vergussmasse umgeben ist.

Die Öffnung des Hohlkörpers kann insbesondere an einer in Steckrichtung vorderen Seite des Hohlkörpers angeordnet oder ausgebildet sein. Die Öffnung kann insbesondere derart am Hohlkörper angeordnet oder ausgebildet sein, dass sich der Hohlraum radial um die Öffnung erstreckt, und/oder derart, dass sich der Hohlraum weiter entgegen der Steckrichtung erstreckt, als die Öffnung.

Der Hohlkörper umfasst den Hohlraum. Der Hohlraum ist insbesondere ein offener Hohlraum, welcher in Steckrichtung nach vorne durch die Öffnung, an der das USB-C Koppelelement angeordnet oder anordenbar ist, geöffnet ist, und insbesondere zusätzlich in Steckrichtung nach hinten durch eine Befüllöffnung geöffnet ist.

Der Hohlkörper kann zumindest abschnittsweise rohrförmig ausgebildet sein, wobei die Rohrform des zumindest abschnittsweise rohrförmig gebildeten Teils des Hohlkörpers ausgebildet ist, den Hohlraum im Wesentlichen in Radialrichtung zu begrenzen. Der zumindest abschnittsweise rohrförmig gebildete Teil des Hohlkörpers kann beispielsweise einen kreisförmigen, einen rechteckigen, oder anderen polygonalen Querschnitt aufweisen.

Dabei ermöglicht der kreisförmige Querschnitt des zumindest abschnittsweise rohrförmig ausgebildeten Hohlkörpers eine einfache Anordnung in einem Koppelgehäuse eines Rundsteckverbinders, sowie eine besonders einfache Anordnung von Dichtmitteln an der Aufnahme, insbesondere an einer Außenumfangsseite der Aufnahme.

Die Öffnung und/oder die Befüllöffnung kann insbesondere eine Erstreckung im Wesentlichen in Axialrichtung der Aufnahme bzw. des Hohlkörpers der Aufnahme aufweisen. Die Befüllöffnung kann insbesondere einen größeren Durchmesser aufweisen, als die Öffnung zur Aufnahme des USB-C Koppelelements. Die Befüllöffnung und die Öffnung zur Anordnung des USB-C Koppelelements können sich in Steckrichtung im Wesentlichen gegenüberliegen, oder mit anderen Worten im Wesentlichen in Steckrichtung gegenüberliegend an dem Hohlkörper angeordnet oder ausgebildet sein.

Das USB-C Koppelelement ist insbesondere formschlüssig an oder in der Öffnung angeordnet, insbesondere derart, dass eine Bewegung des USB-C Koppelelements in Steckrichtung blockiert ist.

Das USB-C Koppelelement ist insbesondere durch die Befüllöffnung des Hohlkörpers in die Öffnung führbar, insbesondere mit dem in Steckrichtung vorderen Teil des USB-C Koppelelements voraus.

Der vorliegende USB-C Steckverbinder stellt vorteilhaft eine einfache, langlebige und insbesondere dichte Anordnung eines USB-C Koppelelements bereit. Der USB-C Steckverbinder ist insbesondere als USB-C Rundsteckverbinder wiederum vorteilhaft einfach, langlebig und dicht mit einem komplementären USB-C Steckverbinder bzw. USB-C Rundsteckverbinder elektrisch leitfähig und/oder datenübertragungsfähig koppelbar.

Beispielshafte, bevorzugte und alternative Ausführungsformen des Aspekts betreffend den USB-C Steckverbinder, sowie deren Effekte, können insbesondere denen entsprechen, wie zum Aspekt betreffend die USB-C Koppelvorrichtung erläutert, und umgekehrt.

Ein weiterer Aspekt der vorliegenden Erfindung betrifft ein USB-C Steckverbindersystem, insbesondere ein USB-C Rundsteckverbindersystem, umfassend:
- einen USB-C Steckverbinder wie vorliegend beschrieben, und
- eine zum USB-C Koppelelement des USB-C Steckverbinders komplementäre Koppeleinheit, welche einen USB-C Anschluss umfasst, welches mit dem USB-C Koppelelement elektrisch leitfähig und/oder datenübertragungsfähig gekoppelt ist.

Die zum USB-C Steckverbinder komplementäre Koppeleinheit kann insbesondere ein komplementärer USB-C Steckverbinder sein, oder ein USB-C Gerät sein, also ein Gerät mit einem zum USB-C Anschluss des USB-C Steckverbinders komplementären USB-C Anschluss.

In bevorzugten Ausführungsformen kann die Aufnahme des USB-C Steckverbinders rückstellfähig, insbesondere elastisch rückstellfähig, an dem Koppelgehäuse des USB-C Steckverbinders angeordnet sein.

Vorzugsweise zusätzlich kann die Aufnahme des zum USB-C Steckverbinder komplementären USB-C Steckverbinders im Wesentlichen starr an dem Koppelgehäuse des komplementären USB-C Steckverbinders angeordnet sein. Alternativ kann die Aufnahme des zum USB-C Steckverbinder komplementären USB-C Steckverbinders (ebenfalls) rückstellfähig, insbesondere elastisch rückstellfähig, an dem Koppelgehäuse des komplementären USB-C Steckverbinders angeordnet sein.

Ist nur eine der beiden Aufnahmen der zueinander komplementären USB-C Steckverbinder rückstellfähig angeordnet, und die andere der beiden Aufnahmen im Wesentlichen starr angeordnet, kann vorteilhaft ein Koppeln der zueinander komplementären USB-C Anschlüsse erleichtert werden, da sich insbesondere während dem Koppeln die Ausrichtung eines der beiden USB-C Anschlüsse an die Ausrichtung des anderen der beiden USB-C Anschlüsse, zumindest vorübergehend, rückstellfähig anpassen kann. Die rückstellfähige Anpassung der Ausrichtung eines der beiden USB-C Anschlüsse durch die rückstellfähige Auslenkung der einen der Aufnahmen, kann insbesondere im gekoppelten Zustand des USB-C Steckverbindersystems zurückgestellt sein.

Das USB-C Steckverbindersystem, welches insbesondere den USB-C Steckverbinder und einen dazu komplementären USB-C Steckverbinder umfasst, wobei beide jeweils insbesondere ein USB-C Rundsteckverbinder sein können, kann insbesondere einen Schutz nach der Schutzart IP 68 im gekoppelten Zustand bilden. Insbesondere können das Koppelgehäuse des USB-C Steckverbinders und das komplementäre Koppelgehäuse des komplementären USB-C Steckverbinders derart komplementär zueinander ausgebildet sein, dass sie einen Schutz nach der Schutzart IP 68 radial innerhalb der beiden Koppelgehäuse bilden oder mit anderen Worten bereitstellen.

Der Schutz bezieht sich dabei insbesondere auf die einen oder mehreren Aufnahmen und/oder auf die einen oder mehreren Koppelelemente, welche innerhalb der zueinander komplementären Koppelgehäuse angeordnet sind.

Das vorliegende USB-C Steckverbindersystem ermöglicht vorteilhaft eine einfache, langlebige und insbesondere dichte elektrisch leitfähige und/oder datenübertragungsfähige Verbindung sicherzustellen.

Beispielshafte, bevorzugte und alternative Ausführungsformen des Aspekts betreffend das USB-C Steckverbindersystem, sowie deren Effekte, können insbesondere denen entsprechen, wie zum Aspekt betreffend die USB-C Koppelvorrichtung und/oder den das USB-C Steckverbinder erläutert, und umgekehrt.

Ein weiterer Aspekt der vorliegenden Erfindung betrifft ein Verfahren zur Herstellung eines USB-C Steckverbinders, insbesondere in dieser Reihenfolge, wobei das Verfahren die Schritte umfasst:
- Bereitstellen eines Koppelgehäuses;
- Bereitstellen einer Aufnahme mit einem Hohlkörper, welcher einen Hohlraum und eine in Steckrichtung nach vorne gerichtete Öffnung aufweist;
- Bereitstellen eines USB-C Koppelelements;
- abschnittsweises Anordnen des USB-C Koppelelements an oder in der Öffnung der Aufnahme;
- Anordnen der Aufnahme am Koppelgehäuse;
- Füllen des Hohlraums mit einer Vergussmasse.

Das abschnittsweise Anordnen des USB-C Koppelelements an oder in der Öffnung der Aufnahme kann insbesondere ein Anordnen des USB-C Koppelelements an oder in der Öffnung umfassen, derart, dass ein in Steckrichtung hinterer Teil des USB-C Koppelelements entgegen der Steckrichtung von der Öffnung vorragt, insbesondere in den Hohlraum des Hohlkörpers hinein.

Zusätzlich oder alternativ kann das abschnittsweise Anordnen des USB-C Koppelelements an oder in der Öffnung ein Anordnen des USB-C Koppelelements an oder in der Öffnung umfassen, derart, dass ein in Steckrichtung vorderer Teil des USB-C Koppelelements, insbesondere der USB-C Anschluss des USB-C Koppelelements, also ein männlicher USB-C Stecker oder eine weibliche USB-C Buchse, in Steckrichtung von der Öffnung vorragt.

Der USB-C Anschluss ist insbesondere derart an oder in der Öffnung der Aufnahme anordenbar, dass der USB-C Anschluss in Radialrichtung zumindest teilweise von der Aufnahme und/oder dem Koppelgehäuse umgeben ist, und insbesondere geschützt aufgenommen ist, beispielsweise berührgeschützt aufgenommen ist, insbesondere nach einem Schutz der Schutzart IP 50 aufgenommen ist.

Dadurch kann vorteilhaft eine USB-C Koppelvorrichtung bereitgestellt werden, in welcher noch vor dem Füllen oder mit anderen Worten Befüllen des Hohlraums mit der Vergussmasse, der USB-C Anschluss bereits geschützt angeordnet ist. Dadurch wird vorteilhaft das Handling der USB-C Koppelvorrichtung sowie deren Weiterverarbeitung zur Herstellung des USB-C Steckverbinders erleichtert. Die Weiterverarbeitung umfasst insbesondere den Schritt des Füllens oder Befüllens des Hohlraums mit der Vergussmasse.

Der Schritt des Füllens oder Befüllen des Hohlraums mit der Vergussmasse kann insbesondere ein Füllen bzw. Befüllen umfassen, wobei ein Teil des USB-C Koppelelements zumindest abschnittsweise von der Vergussmasse umgeben ist bzw. wird.

Der Schritt des Füllens oder Befüllens kann optional zusätzlich insbesondere ein Füllen eines Spiel-aufweisenden Bereichs der Öffnung aufweisen, in dem die Öffnung des Hohlkörpers relativ zum daran oder darin angeordneten USB-C Koppelelements ein Spiel aufweist.

Die Verfahrensschritte des Bereitstellens des Koppelgehäuses, der Aufnahme mit dem Hohlkörper und des USB-C Koppelelements sind insbesondere in zueinander beliebiger Reihenfolge durchführbar. Die Schritte des Bereitstellens können beispielsweise durch einen Schritte des Bereitstellens des Koppelgehäuses, der Aufnahme mit dem Hohlkörper, welcher einen Hohlraum und eine in Steckrichtung nach vorne gerichtete Öffnung aufweist, und des USB-C Koppelelements durchgeführt werden.

Die Verfahrensschritte des abschnittsweise Anordnens des USB-C Koppelelements in der Öffnung der Aufnahme und des Anordnens der Aufnahme am Koppelgehäuse sind in zueinander beliebiger Reihenfolge durchführbar. Das vorherige abschnittsweise Anordnen des USB-C Koppelelements ermöglicht jedoch vorteilhaft eine einfachere Vormontage des USB-C Koppelelements an der Aufnahme, welche insbesondere nicht durch eine Geometrie des Koppelgehäuses eingeschränkt oder begrenzt ist.

In beispielhaften Ausführungsformen kann der Schritt des Füllens des Hohlraums mit der Vergussmasse vor dem Schritt des Anordnens der Aufnahme am Koppelgehäuse erfolgen.

Ohne den Verfahrensschritt des Füllens des Hohlraums mit der Vergussmasse und insbesondere ohne den Schritt des abschnittsweisen Anordnens des USB-C Koppelelements an oder in der Öffnung stellen die vorgenannten Schritte insbesondere ein Verfahren zur Herstellung einer USB-C Koppelvorrichtung bereit.

Das vorliegende Verfahren zur Herstellung ermöglicht vorteilhaft einfach einen langlebigen und insbesondere dichten elektrisch leitfähigen und/oder datenübertragungsfähigen Steckverbinder bereitzustellen.

Beispielshafte, bevorzugte und alternative Ausführungsformen des Aspekts betreffend das Verfahren zur Herstellung eines USB-C Steckverbinders, sowie deren Effekte, können insbesondere denen entsprechen, wie zum Aspekt betreffend die USB-C Koppelvorrichtung, den USB-C Steckverbinder und/oder das USB-C Steckverbindersystem erläutert, und umgekehrt.

Weitere Aspekte der vorliegenden Erfindung betreffen eine Koppelvorrichtung, einen Steckverbinder, insbesondere Rundsteckverbinder, ein Steckverbindersystem, insbesondere Rundsteckverbinder, sowie ein Verfahren zur Herstellung eines Steckverbinders, welche den jeweiligen Aspekten der USB-C Koppelvorrichtung, des USB-C Steckverbinders, insbesondere USB-C Rundsteckverbinders, des USB-C Steckverbindersystems, insbesondere USB-C Rundsteckverbindersystems, sowie des Verfahrens zur Herstellung eines USB-C Steckverbinders entsprechen, mit der Ausnahme, dass das Koppelelement nicht auf ein USB-C Koppelelement beschränkt ist, sondern ein Koppelelement mit einem oder mehreren von einem USB-C Anschluss abweichenden Anschlüssen aufweisen kann, also einen Anschluss aufweisen kann, welcher nicht auf den USB-C Anschluss beschränkt ist.

Im Folgenden werden Ausführungsformen der Erfindung anhand der beiliegenden Figuren näher beschrieben. Es versteht sich, dass die vorliegende Erfindung nicht auf diese Ausführungsformen beschränkt sind, und dass einzelne Merkmale der Ausführungsformen im Rahmen der beiliegenden Ansprüche zu weiteren Ausführungsformen kombiniert werden können.

Ist vorliegend und im Folgenden von einem komplementären Element die Rede, betrifft dies insbesondere das damit bezeichnete Element. Der Begriff "komplementär" betont lediglich die komplementäre Ausbildung des komplementären Elements zum jeweiligen Element, welches ohne den Begriff "komplementär" bezeichnet ist. Sofern nicht anders hervorgehoben, beziehen sich die vorliegenden sowie die zu den Figuren folgenden Erläuterungen sowohl auf das Element, sowie auf das dazu "komplementär" bezeichnete Element.

Es zeigt:
- Figur 1a: ein Steckverbindersystem, gemäß einer Ausführungsform der vorliegenden Erfindung;
- Figur 1b: ein Steckverbinder und ein dazu komplementärer Steckverbinder, gemäß einer Ausführungsform der vorliegenden Erfindung;
- Figur 2a: eine Schnittansicht eines Steckverbinders, gemäß einer Ausführungsform der vorliegenden Erfindung;
- Figur 2b: eine Schnittansicht eines Steckverbinders, gemäß einer Ausführungsform der vorliegenden Erfindung;
- Figur 3a: eine Schnittansicht eines Steckverbinders, gemäß einer Ausführungsform der vorliegenden Erfindung;
- Figur 3b: eine Schnittansicht eines Steckverbinders, gemäß einer Ausführungsform der vorliegenden Erfindung;
- Figur 4a: eine Ansicht eines in einer Aufnahme angeordneten Koppelelements, gemäß einer Ausführungsform der vorliegenden Erfindung;
- Figur 4b: eine Schnittansicht eines in einer Aufnahme angeordneten Koppelelements, gemäß einer Ausführungsform der vorliegenden Erfindung;
- Figur 5a: eine Schnittansicht eines Steckverbindersystems, gemäß einer Ausführungsform der vorliegenden Erfindung;
- Figur 5b: eine Schnittansicht eines Steckverbindersystems, gemäß einer Ausführungsform der vorliegenden Erfindung; und
- Figur 6: ein Flussdiagramm eines Verfahrens zur Herstellung eines Steckverbinders, gemäß einer Ausführungsform der vorliegenden Erfindung.

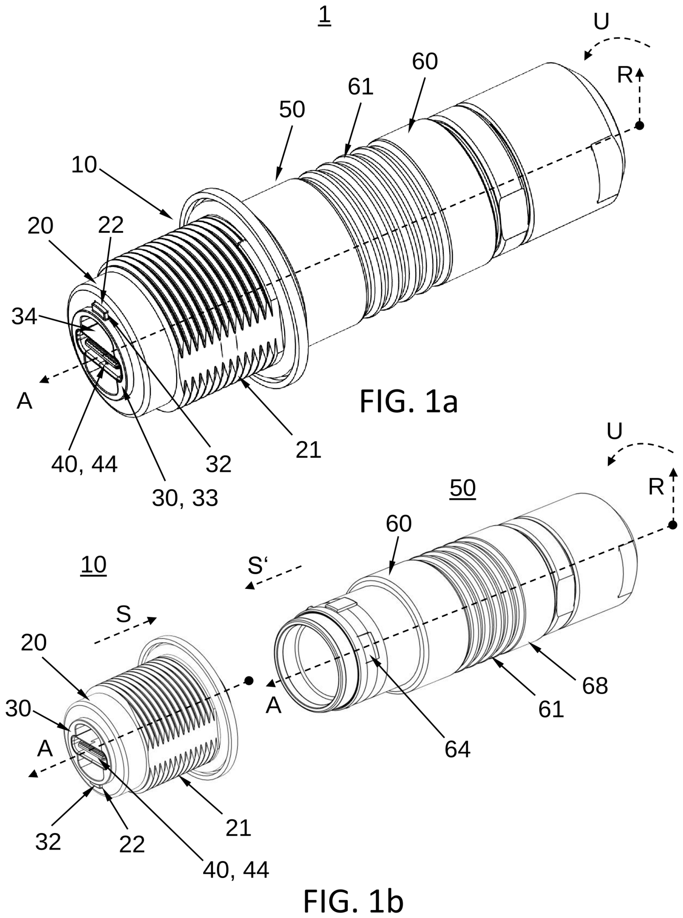

Fig. 1a zeigt ein USB-C Steckverbindersystem 1, insbesondere USB-C Rundsteckverbindersystem 1, gemäß einer Ausführungsform der vorliegenden Erfindung. Das USB-C Steckverbindersystem 1, wie in Fig. 1a gezeigt, gibt insbesondere einen gekoppelten Zustand eines ersten USB-C Steckverbinders 10 mit einem zweiten, zum ersten USB-C Steckverbinder 10 komplementären USB-C Steckverbinder 50 wieder.

Fig. 1b zeigt einen ersten USB-C Steckverbinder 10, insbesondere USB-C Rundsteckverbinder 10, und einen zum ersten USB-C Steckverbinder 10 komplementären zweiten USB-C Steckverbinder 50, insbesondere USB-C Rundsteckverbinder 50, jeweils gemäß einer Ausführungsform der vorliegenden Erfindung. Die in Fig. 1b gezeigten ersten und zweiten USB-C Steckverbinder 10, 50 können insbesondere denen des USB-C Steckverbindersystems 1 entsprechen. Der ersten und zweite USB-C Steckverbinder 10, 50, wie in Fig. 1b gezeigt, geben insbesondere einen entkoppelten Zustand oder nicht-gekoppelten Zustand eines USB-C Steckverbindersystems 1 wieder. Der erste USB-C Steckverbinder 10 ist mit dem zweiten, zum ersten USB-C Steckverbinder 10 komplementären USB-C Steckverbinder 50 koppelbar, insbesondere elektrisch leitfähig und/oder datenübertragungsfähig koppelbar, insbesondere zu einem USB-C Steckverbindersystem 1 koppelbar, wie in Fig. 1a gezeigt. wieder.

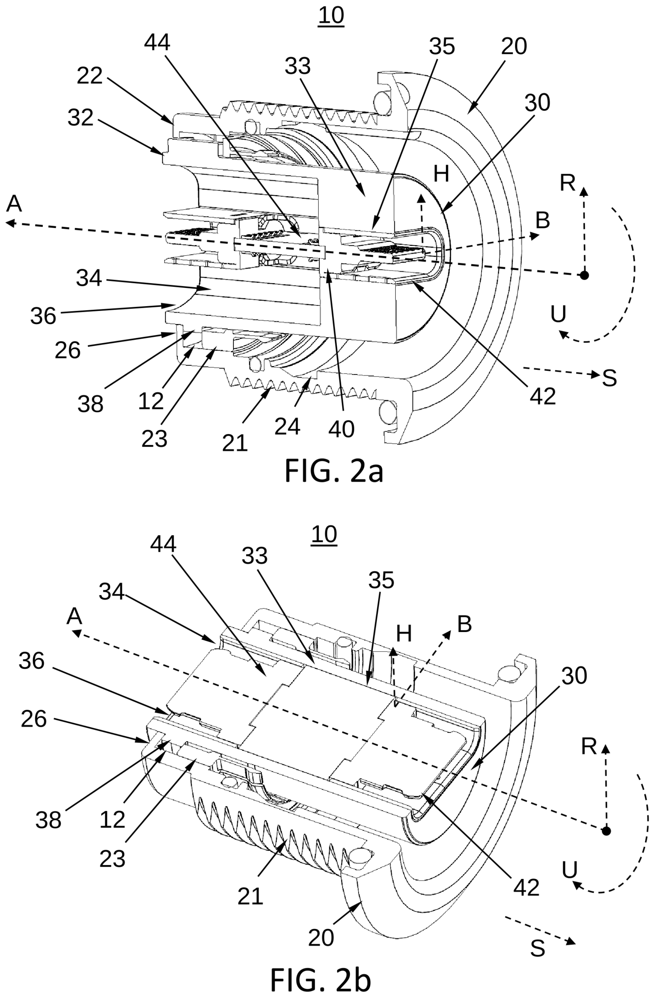

Fig. 2a zeigt eine Schnittansicht eines ersten USB-C Steckverbinders 10, insbesondere USB-C Rundsteckverbinders 10, gemäß einer Ausführungsform der vorliegenden Erfindung. Der in Fig. 2a gezeigte erste USB-C Steckverbinder 10 kann insbesondere dem der Figuren 1a und 1b entsprechen. Die Schnittebene der in Fig. 2a gezeigten Schnittansicht erstreckt sich im Wesentlichen in Axialrichtung A und in Radialrichtung R, insbesondere in der Radialrichtung R, welche im Wesentlichen parallel zur Höhenrichtung H ist. Die Höhenrichtung H entspricht insbesondere der Richtung, in welcher der USB-C Anschluss 42 des ersten USB-C Steckverbinders 10 dünn ist, oder mit anderen Worten seine kleinste Erstreckung aufweist.

Fig. 2b zeigt eine Schnittansicht eines ersten USB-C Steckverbinders 10, insbesondere USB-C Rundsteckverbinders 10, gemäß einer Ausführungsform der vorliegenden Erfindung. Der in Fig. 2b gezeigte erste USB-C Steckverbinder 10 kann insbesondere dem der Figuren 1a, 1b und 2a entsprechen. Die Schnittebene der in Fig. 2b gezeigten Schnittansicht erstreckt sich im Wesentlichen in Axialrichtung A und in Radialrichtung R, insbesondere in der Radialrichtung R, welche im Wesentlichen parallel zur Breitenrichtung B oder mit anderen Worten im Wesentlichen senkrecht zur Höhenrichtung H ist. Die Breitenrichtung B entspricht insbesondere der Richtung, in welcher der USB-C Anschluss 42 des ersten USB-C Steckverbinders 10 breit ist, oder mit anderen Worten seine Haupterstreckung aufweist.

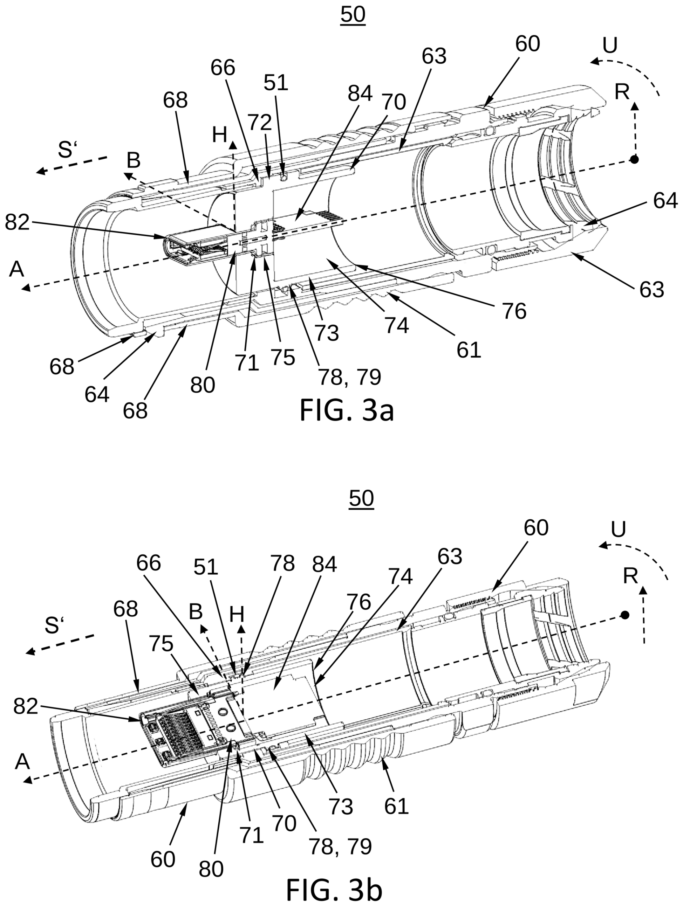

Fig. 3a zeigt eine Schnittansicht eines zweiten USB-C Steckverbinders 50, insbesondere USB-C Rundsteckverbinders 50, gemäß einer Ausführungsform der vorliegenden Erfindung. Der in Fig. 3a gezeigte zweite USB-C Steckverbinder 50 kann insbesondere dem der Figuren 1a und 1b entsprechen. Die Schnittebene der in Fig. 3a gezeigten Schnittansicht erstreckt sich im Wesentlichen in Axialrichtung A und in Radialrichtung R, insbesondere in der Radialrichtung R, welche im Wesentlichen parallel zur Höhenrichtung H ist. Die Höhenrichtung H entspricht insbesondere der Richtung, in welcher der USB-C Anschluss 82 des zweiten USB-C Steckverbinders 50 dünn ist, oder mit anderen Worten seine kleinste Erstreckung aufweist. Die Schnittebene kann daher insbesondere derjenigen entsprechen, wie in Fig. 2a für den ersten USB-C Steckverbinder 10 gezeigt.

Fig. 3b zeigt eine Schnittansicht eines zweiten USB-C Steckverbinders 50, insbesondere USB-C Rundsteckverbinders 50, gemäß einer Ausführungsform der vorliegenden Erfindung. Der in Fig. 3b gezeigte zweite USB-C Steckverbinder 50 kann insbesondere dem der Figuren 1a, 1b und 3a entsprechen. Die Schnittebene der in Fig. 3b gezeigten Schnittansicht erstreckt sich im Wesentlichen in Axialrichtung A und in Radialrichtung R, insbesondere in der Radialrichtung R, welche im Wesentlichen parallel zur Breitenrichtung B oder mit anderen Worten im Wesentlichen senkrecht zur Höhenrichtung H ist. Die Breitenrichtung B entspricht insbesondere der Richtung, in welcher der USB-C Anschluss 82 des zweiten USB-C Steckverbinders 50 breit ist, oder mit anderen Worten seine Haupterstreckung aufweist. Die Schnittebene kann daher insbesondere derjenigen entsprechen, wie in Fig. 2b für den ersten USB-C Steckverbinder 10 gezeigt.

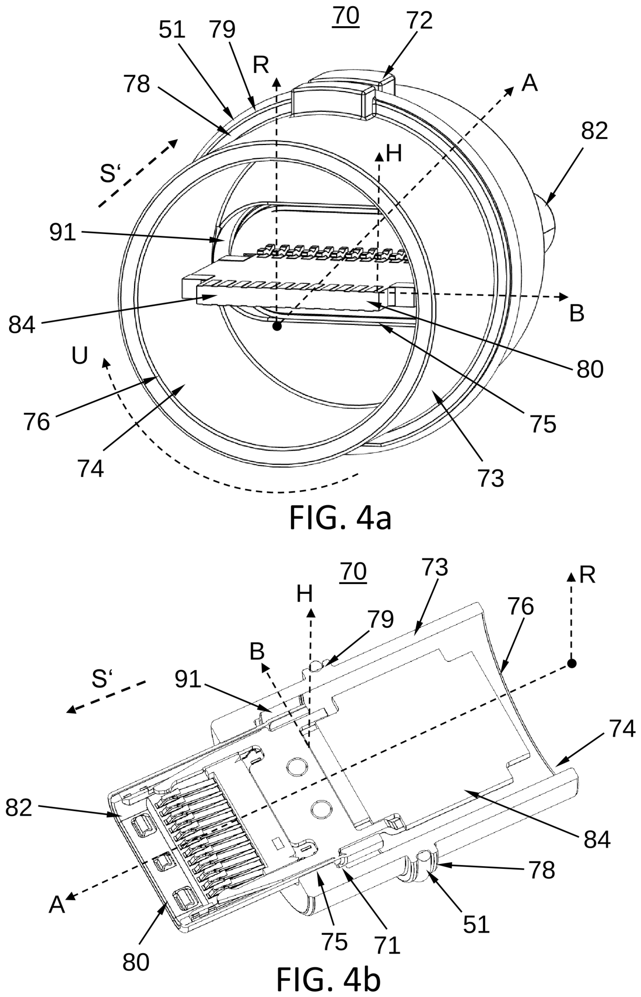

Fig. 4a zeigt eine Ansicht eines in einer Aufnahme 70 angeordneten USB-C Koppelelements 80, gemäß einer Ausführungsform der vorliegenden Erfindung. Die in Fig. 4a gezeigte Aufnahme 70 kann insbesondere der Aufnahme 70 des zweiten USB-C Steckverbinders 50 entsprechen, wie insbesondere in den Figuren 1a, 1b, 3a und 3b gezeigt.

Fig. 4b zeigt eine Schnittansicht eines in einer Aufnahme 70 angeordneten USB-C Koppelelements 80, gemäß einer Ausführungsform der vorliegenden Erfindung. Die in Fig. 4b gezeigte Aufnahme 70 kann insbesondere der Aufnahme 70 des zweiten USB-C Steckverbinders 50 entsprechen, wie insbesondere in den Figuren 1a, 1b, 3a, 3b und 4a gezeigt.

Wie durch die Figuren 2a, 2b, 3a und 3b verdeutlicht, kann die Aufnahme 30 des ersten USB-C Steckverbinders 10 verschieden zur Aufnahme 70 des zweiten USB-C Steckverbinders 50 ausgebildet sein. Dadurch kann vorteilhaft der jeweiligen Anordnung eines speziellen USB-Koppelelements 40, 80 Rechnung getragen werden, welche insbesondere in Steckrichtung S, S' zugewandt zueinander komplementär, jedoch nicht gleich ausgebildet sind.

In beispielhaften Ausführungsformen des ersten USB-C Steckverbinders 10 kann die Aufnahme 30 entsprechend der Aufnahme 70 des zweiten USB-C Steckverbinders 50 ausgebildet sein, wie insbesondere in den Figuren 4a und 4b gezeigt. Dann ist die Ausbildung der Aufnahme 30 des ersten USB-C Steckverbinders 10 derart, dass sie in Steckrichtung S der Ausbildung der Aufnahme 70 des zweiten USB.C Steckverbinders 50 in deren Steckrichtung S' entspricht. Mit anderen Worten sind die einander im Wesentlichen in Axialrichtung A gegenüberliegenden Aufnahmen 40, 70, im miteinander gekoppelten Zustand des ersten und zweiten USB-C Steckverbinders zumindest abschnittsweise oder im Wesentlichen spiegelverkehrt.

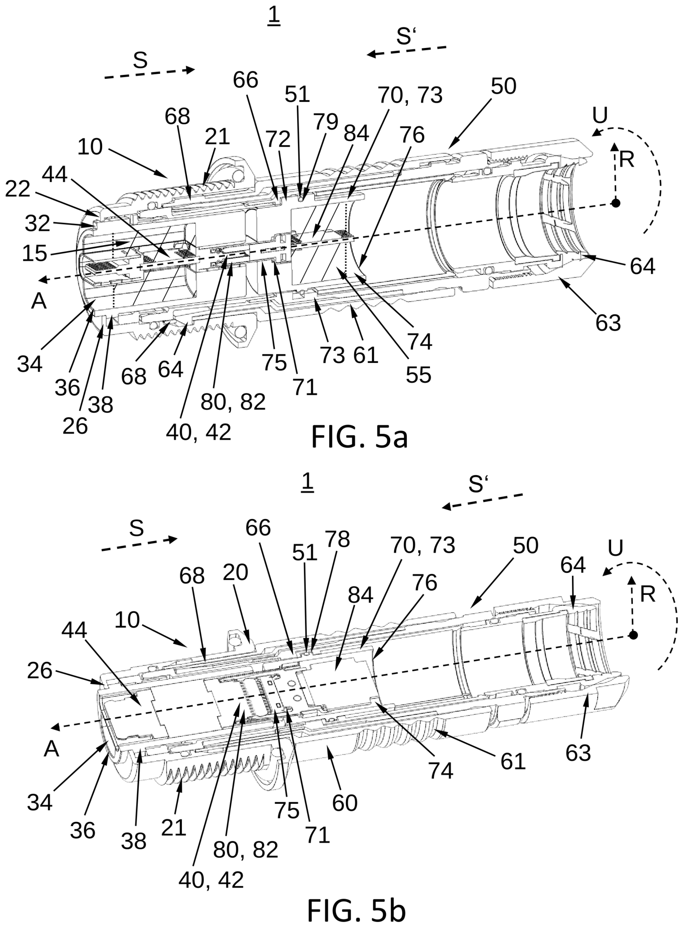

Fig. 5a zeigt eine Schnittansicht eines USB-C Steckverbindersystems 1, gemäß einer Ausführungsform der vorliegenden Erfindung. Das in Fig. 5a gezeigte USB-C Steckverbindersystem 1 kann insbesondere dem der Figur 1a entsprechen, und insbesondere den ersten und zweiten USB-C Steckverbinder 10, 50 aufweisen, wie in den Figuren 1b, 2a, 2b, 3a, 3b, 4a und 4b gezeigt. Die Schnittebene der in Fig. 5a gezeigten Schnittansicht erstreckt sich im Wesentlichen in Axialrichtung A und in Radialrichtung R, insbesondere in der Radialrichtung R, welche im Wesentlichen parallel zur Höhenrichtung H ist. Die Höhenrichtung H entspricht insbesondere der Richtung, in welcher die USB-C Anschlüsse 42, 82 des ersten und zweiten USB-C Steckverbinders 10, 50 dünn ist, oder mit anderen Worten seine kleinste Erstreckung aufweist. Die Schnittebene kann daher insbesondere derjenigen entsprechen, wie in den Figuren 2a und 3a für den ersten und zweiten USB-C Steckverbinder 10, 50 gezeigt.

Fig. 5a gibt insbesondere einen gekoppelten Zustand des ersten USB-C Steckverbinders 10 mit dem zweiten USB-C Steckverbinder 50 wieder.

Fig. 5b zeigt eine Schnittansicht eines USB-C Steckverbindersystems 1, gemäß einer Ausführungsform der vorliegenden Erfindung. Das in Fig. 5b gezeigte USB-C Steckverbindersystem 1 kann insbesondere dem der Figuren 1a und 5a entsprechen, und insbesondere den ersten und zweiten USB-C Steckverbinder 10, 50 aufweisen, wie in den Figuren 1b, 2a, 2b, 3a, 3b, 4a und 4b gezeigt. Die Schnittebene der in Fig. 5b gezeigten Schnittansicht erstreckt sich im Wesentlichen in Axialrichtung A und in Radialrichtung R, insbesondere in der Radialrichtung R, welche im Wesentlichen parallel zur Breitenrichtung B oder mit anderen Worten im Wesentlichen senkrecht zur Höhenrichtung H ist. Die Breitenrichtung B entspricht insbesondere der Richtung, in welcher der USB-C Anschluss 42, 82 des ersten und zweiten USB-C Steckverbinders 10, 50 breit ist, oder mit anderen Worten seine Haupterstreckung aufweist. Die Schnittebene kann daher insbesondere derjenigen entsprechen, wie in den Figuren 2b und 3b für den ersten und zweiten USB-C Steckverbinder 10, 50 gezeigt.

In den Figuren 1a bis 4b und 5b ist die Vergussmasse 15, 55 zur Übersichtlichkeit nicht mit dargestellt. Jedoch ist die Vergussmasse 15, 55 in Fig. 5a durch die beispielhaft gezeigte Schraffur innerhalb des Hohlraums 34 der Aufnahme 30 des ersten USB-C Steckverbinders 10 und innerhalb des Hohlraums 74 der Aufnahme 70 des zweiten USB-C Steckverbinders 50 für einen punktiert dargestellten beispielhaften Füllstand wiedergegeben.

Wie durch die Figuren 1a und 1b gezeigt, kann das Steckverbindersystem 1 insbesondere ein Rundsteckverbindersystem 1 sein, und insbesondere einen ersten USB-C Steckverbinder 10, insbesondere USB-C Rundsteckverbinder 10, und einen zweiten USB-C Steckverbinder 50, insbesondere USB-C Rundsteckverbinder 50, umfassen.

Der erste USB-C Steckverbinder 10 ist insbesondere im Wesentlichen in Steckrichtung S mit dem zweiten USB-C Steckverbinders 50 koppelbar. Die Steckrichtung S des ersten USB-C Steckverbinders 10, wie in den Figuren gezeigt, ist insbesondere im Wesentlichen parallel entgegengesetzt zur Axialrichtung A des USB-C Steckverbindersystems 1.

Der zweite USB-C Steckverbinder 50 ist insbesondere im Wesentlichen in Steckrichtung S' mit dem ersten USB-C Steckverbinders 10 koppelbar. Die Steckrichtung S' des zweiten USB-C Steckverbinders 50, wie in den Figuren gezeigt, kann insbesondere im Wesentlichen der Axialrichtung A des USB-C Steckverbindersystems 1 entsprechend, und ist insbesondere. Im Wesentlichen parallel entgegengesetzt zur Steckrichtung S des ersten USB-C Steckverbinders 10.

Der erste und/oder der zweite USB- Steckverbinders 10, 50, können insbesondere im Wesentlichen rohrförmig oder mit anderen Worten zylindrisch ausgebildet sein.

Wie durch die Figuren 1a bis 5b gezeigt, weist Aufnahme 30, 70 insbesondere einen Hohlkörper 33, 73 auf, welcher zumindest abschnittsweise einen Hohlraum 34, 74 aufweist oder umgrenzt, insbesondere zumindest in Radialrichtung R umgrenzt. Der Hohlkörper 33, 73 kann insbesondere zumindest abschnittsweise im Wesentlichen hohlzylindrisch ausgebildet sein, insbesondere an einem in Steckrichtung S, S' hinteren Ende der Aufnahme 30, 70. In Steckrichtung S, S' nach vorne kann der Hohlraum 34, 74 insbesondere an die Öffnung 35, 75 angrenzen, welche ausgebildet ist das USB-C Koppelelement 40, 80 abschnittsweise aufzunehmen.

Die Öffnung 35, 75 kann insbesondere im Wesentlichen durch das USB-C Koppelelement 40, 80 verschlossen sein. Insbesondere kann die Öffnung 35, 75, in einem Zustand, in dem das USB-C Koppelelement an oder in der Öffnung 35, 75 angeordnet ist, für die Vergussmasse 15, 55 im Wesentlichen dicht verschlossen sein, also so dass die Vergussmasse 15, 55 bei einem Schritt des Füllens des Hohlraums 34, 74 nicht durch die Öffnung 35, 75 hindurchtropft.

Wie durch die Figuren 1a, 1b, 2a, 3a, 4a und 5a gezeigt, Die Aufnahme 30, 70 insbesondere eine Aufnahmecodierung 32, 72 aufweisen, welche insbesondere ausgebildet ist, mit einer zur Aufnahmecodierung 32, 72 komplementären gehäuseseitigen Aufnahmecodierung 22, 62 des Koppelgehäuses 20, 60 in Eingriff zu sein, oder beim Anordnen der Aufnahme 30, 70 an oder in dem Koppelgehäuse 20, 60 in Eingriff zu gelangen.

Die Aufnahmecodierung 32, 72 kann insbesondere im Wesentlichen in Radialrichtung R von der Aufnahme 30, 70 vorspringen, und insbesondere eine vorbestimmte Erstreckung entlang der Umfangsrichtung U aufweisen. Dadurch kann die Aufnahmecodierung 32, 72 insbesondere eine Codierung in Umfangsrichtung U bereitstellen, welche mit der gehäuseseitigen Aufnahmecodierung 22, 62 in Eingriff ist bzw. in Eingriff bringbar ist.

Dadurch kann vorteilhaft eine vorbestimmte Ausrichtung der Aufnahme 30, 70 am Koppelgehäuse 20, 60 sichergestellt werden, und beispielsweise insbesondere weitere nachgelagerte Montageschritte zur Herstellung des USB-C Steckverbinders 10, 50 vorteilhaft vereinfacht werden.

Alternativ oder zusätzlich kann die Aufnahme 30, 70 insbesondere einen Aufnahmevorsprung 38, 78 aufweisen, welcher insbesondere ausgebildet ist, mit einem Anschlag 26, 66 des Koppelgehäuses 20, 60 in Eingriff bzw. in Anschlag zu sein, oder beim Anordnen der Aufnahme 30, 70 an oder in dem Koppelgehäuse 20, 60 in Eingriff bzw. in Anschlag zu gelangen.

Der Aufnahmevorsprung 38, 78 kann insbesondere im Wesentlichen in Radialrichtung R von der Aufnahme 30, 70 vorspringen und insbesondere eine vorbestimmte Erstreckung entlang der Umfangsrichtung U aufweisen. Der Aufnahmevorsprung 38, 78 kann insbesondere in Steckrichtung S, S' oder Axialrichtung A, und/oder in Radialrichtung R eine andere Erstreckung aufweisen, als die Aufnahmecodierung 32, 72. In Umfangsrichtung U kann der Aufnahmevorsprung 38, 78 an die Aufnahmecodierung 32, 72 angrenzen, ist darauf jedoch nicht beschränkt. Der Aufnahmevorsprung 38, 78 kann in Umfangsrichtung U insbesondere eine Erstreckung von mehr als etwa 180° umfassen, insbesondere von mehr als etwa 270° umfassen, insbesondere im Bereich von etwa 270° bis etwa 330° umfassen.

Der Anschlag 26, 66 kann insbesondere ein sich im Wesentlichen in Radialrichtung R erstreckender Vorsprung sein, insbesondere ein im Wesentlichen in Radialrichtung R einwärts erstreckender Vorsprung sein. Der Anschlag 26, 66 kann abschnittsweise oder durchgängig entlang der Umfangrichtung U ausgebildet sein.

Dadurch kann vorteilhaft ein flächiger, insbesondere formschlüssiger Eingriff oder Anschlag der Aufnahme 30, 70 mit dem Koppelgehäuse 20, 60 sichergestellt werden.

Wie insbesondere in Fig. 2a beispielhaft gezeigt, ist in einem Eingriffsbereich 12, in dem der Aufnahmevorsprung 38 des ersten USB-C Steckverbinders 10 mit dem Anschlag 26 in Eingriff ist, ein elastisch rückstellfähiges Element (nicht gezeigt) zur dichten und/oder elastisch rückstellfähigen Anordnung, und insbesondere vorgespannten Anordnung, der Aufnahme 30 am Koppelgehäuse 20 anordenbar. Das elastisch rückstellfähige Element kann insbesondere ein Dichtring, beispielsweise ein O-Ring sein.

Wie insbesondere in Fig. 3a beispielhaft gezeigt, kann die Aufnahme 70 des zweiten USB-C Steckverbinders 50 insbesondere eine Nut 79 an einer Außenumfangsseite der Aufnahme 70 aufweisen, wobei sich die Nut 79 teilweise oder vollständig umlaufend in Umfangsrichtung U erstrecken kann.

In der Nut 79 ist insbesondere ein rückstellfähiges Element 51, insbesondere elastisch rückstellfähiges Element 51 angeordnet, wie beispielsweise ein Dichtring, insbesondere ein O-Ring.

Die Nut 79 kann insbesondere am Aufnahmevorsprung 78 ausgebildet sein, ist darauf jedoch nicht beschränkt. Die Ausbildung am Aufnahmevorsprung 78 ermöglicht jedoch vorteilhaft das rückstellfähige Element 51 radial außen an der Aufnahme 70 anzuordnen, wodurch eine definierte vorgespannte Anordnung relativ zum Koppelgehäuse 60 einstellbar ist.

In bevorzugten Ausführungsformen des USB-C Steckverbindersystems 1, und wie in den Figuren 5a und 5b gezeigt, ist nur eine Aufnahme 30, 70 des ersten USB-C Steckverbinders 10 oder des zweiten USB-C Steckverbinders 50 rückstellfähig vorgespannt am jeweiligen Koppelgehäuse 20, 60 angeordnet.

Dadurch kann vorteilhaft das gegenseitige Koppeln erleichtert werden, wobei die eine Aufnahme 30, 70 zumindest vorübergehend rückstellfähig in dem jeweiligen Koppelgehäuse 20, 60 ausgelenkt wird, während die andere Aufnahme 30, 70 führend, im Wesentlichen starr, am anderen Koppelgehäuse 20, 60 gehalten ist bzw. bleibt.

Wie durch die Figuren 2a bis 5b beispielhaft gezeigt, ist das USB-C Koppelelement 40, 80 abschnittsweise in der insbesondere in Steckrichtung S, S' vorderen Öffnung 35, 75 angeordnet. Die abschnittsweise Anordnung ist dabei derart, dass der in Steckrichtung S, S' vordere Teil 42, 82 des USB-C Koppelelements 40, 80 in Steckrichtung S, S' aus der Öffnung 35, 75 ragt, und/oder der in Steckrichtung S, S' hintere Teil 44, 84 des USB-C Koppelelements 40, 80 entgegen der Steckrichtung S, S' aus der Öffnung 35, 75 ragt. Der in Steckrichtung S, S' hintere Teil des USB-C Koppelelements 40, 80 kann mit anderen Worten insbesondere zumindest abschnittsweise in den Hohlraum 34, 74 hineinragen, insbesondere in den vom Hohlkörper 33, 73 zumindest radial begrenzen Hohlraum 34, 74 hineinragen.

Dadurch ist vorteilhaft insbesondere der in Steckrichtung S, S' hintere Teil 42, 82 des USB-C Koppelelements 40, 80 durch die Vergussmasse 15, 55 einbettbar und insbesondere in der Aufnahme 30, 70 fixierbar.

Der in Steckrichtung S, S' hintere Teil 42, 82 des USB-C Koppelelements 40, 80 kann Kontaktelemente des USB-Koppelelements 40, 80, insbesondere lötbare Kontaktelemente, eine Leiterplatte, insbesondere eine PCB (printed circuit board), ein Kabel, einen männlichen USB-C Stecker und/oder eine weiblichen USB-C Buchse umfassen oder daraus bestehen.

Wie in den Figuren 2a, 2b, 5a und 5b beispielhaft anhand des ersten USB-C Steckverbinders 10 gezeigt, kann das USB-C Koppelelement 40 insbesondere derart in der Öffnung 35 der Aufnahme 30 angeordnet sein, dass der Anschluss des USB-C Koppelelements 40, also beispielhaft die USB-C Buchse als in Steckrichtung S vorderer Teil 42 bündig in der Öffnung 35 aufgenommen ist. Insbesondere ist die Aufnahme 30 ausgebildet, den in Steckrichtung S vorderen Teil 42 des USB-C Koppelelements 40 in Umfangsrichtung U zu umgeben, und sich insbesondere im Wesentlichen bis zu einem in Steckrichtung S oder Axialrichtung A vorderen Ende des vorderen Teils 42 zu erstrecken.

Dadurch wird der vordere Teil 42 des USB-C Koppelelements 40 vorteilhaft geschützt, und insbesondere vor Berührungen, Staub, und/oder Fremdkörpern geschützt. Die Öffnung 35 der Aufnahme 30 ist insbesondere ausgebildet, an einem in Steckrichtung S rückwärtigen Ende des vorderen Teils 42 bündig abzuschließen.

Dadurch wird vorteilhaft eine einfache optische Prüfung der Anordnung des USB-C Koppelelements 40 an oder in der Aufnahme 30 ermöglicht. Zudem kann vorteilhaft ein ungewünschtes Fließen der Vergussmasse 15 von der in Steckrichtung S hinteren Seite nach vorne, bis in den in Steckrichtung S vorderen Teil 42 des USB-C Koppelelements 40, erschwert oder verhindert werden. Dadurch kann wiederum eine zuverlässige Steckbarkeit und Kontaktierbarkeit des vorderen Teils 42 sichergestellt werden.

Wie anhand des USB-C Koppelelements 40 des ersten USB-C Steckverbinders 10 beispielhaft gezeigt, kann das USB-C Koppelelement 40 insbesondere reibschlüssig an oder in der Aufnahme 30 angeordnet sein oder werden, insbesondere vor einem Befüllen mit Vergussmasse 15.

Wie in den Figuren 3a, 3b, 5a und 5b beispielhaft anhand des zweiten USB-C Steckverbinders 50 gezeigt, kann das USB-C Koppelelement 80 insbesondere formschlüssig in der Öffnung 75 der Aufnahme 70 angeordnet sein. Die Öffnung 75 kann insbesondere an einer Innenumfangsseite einen Stufenabschnitt 71 aufweisen, so dass sich die Öffnung 75 in Axialrichtung A oder in Steckrichtung S' verkleinert oder mit anderen Worten verjüngt. Der Stufenabschnitt 71 kann insbesondere einen in Steckrichtung S' stirnseitigen Anschlag zum Anschlagen für das USB-C Koppelelement 80 aufweisen oder bereitstellen.

Dadurch wird vorteilhaft die Montage oder Herstellung des USB-C Steckverbinders 50, also insbesondere das abschnittsweise Anordnen des USB-C Koppelelements 80 an oder in der Öffnung 75 der Aufnahme 70 vereinfacht.

Das USB-C Koppelelement 80 kann insbesondere derart in der Öffnung 75 der Aufnahme 70 angeordnet sein, dass der Anschluss des USB-C Koppelelements 80, also beispielhaft der USB-C Stecker als in Steckrichtung S vorderer Teil 82 von der Öffnung 75 in Steckrichtung S' vorragt. Insbesondere ist das Koppelgehäuse 60 ausgebildet, den in Steckrichtung S vorderen Teil 82 des USB-C Koppelelements 80 in Umfangsrichtung U zu umgeben, und sich insbesondere weiter in Steckrichtung S' oder Axialrichtung A zu erstrecken, als ein in Steckrichtung S' vorderes Ende des vorderen Teils 82.

Dadurch kann der vordere Teil 82 des USB-C Koppelelements 80 vorteilhaft geschützt werden, und insbesondere berührgeschützt angeordnet werden, und/oder mit einem Schutz nach der Schutzart IP 50 angeordnet werden. Im gekoppelten Zustand des Steckverbindersystems 1, insbesondere mittels der Vergussmassen 15, 55 sowie den zwischen den Koppelgehäusen 20, 60 angeordneten Dichtringe, kann das Steckverbindersystem 1 insbesondere einen Schutz nach der Schutzart IP 68 für die USB-C Koppelelemente 40, 80 aufweisen oder bereitstellen.

Die Öffnung 75 der Aufnahme 70 ist insbesondere ausgebildet, an einem in Steckrichtung S' rückwärtigen Ende des vorderen Teils 82 bündig abzuschließen.

Dadurch wird vorteilhaft eine einfache optische Prüfung der Anordnung des USB-C Koppelelements 80 an oder in der Aufnahme 70 ermöglicht. Zudem kann vorteilhaft ein ungewünschtes Fließen der Vergussmasse 55 von der in Steckrichtung S' hinteren Seite nach vorne, bis in den in Steckrichtung S vorderen Teil 82 des USB-C Koppelelements 80, erschwert oder verhindert werden. Dadurch kann wiederum eine zuverlässige Steckbarkeit und Kontaktierbarkeit des vorderen Teils 82 sichergestellt werden.

Wie durch die Figuren 2a bis 5b gezeigt, ist die Aufnahme 30, 70 beispielsweise befüllbar, indem die Aufnahme 30, 70 und/oder das Koppelgehäuse 20, 60 in welcher die Aufnahme 30, 70 gegebenenfalls angeordnet ist, derart gestellt wird, dass die Vergussmasse 15, 55 von oben, durch die in Steckrichtung S, S' rückwärtige Befüllöffnung 36, 76 befüllbar ist.

Dabei kann der in Steckrichtung S, S' hintere Teil 44, 84 des Koppelelements 40, 80 gehalten werden, insbesondere in einer vorbestimmten und/oder anwendungsspezifischen Richtung gehalten werden, wodurch vorteilhaft eine vorbestimmte und insbesondere anwendungsspezifische Ausrichtung des in Steckrichtung S, S' hinteren Teils 44, 84 sichergestellt werden kann.

Wie beispielhaft anhand des ersten USB-C Steckverbinders 10 gezeigt, kann der USB-C Steckverbinder 10 einen Fixierring 23 aufweisen, welcher ausgebildet ist, die Aufnahme 30 an dem Koppelgehäuse 20 zu fixieren, insbesondere formschlüssig zu fixieren.

Zusammen mit dem Anschlag 26 kann der Fixierung 23 beispielsweise eine formschlüssige Fixierung der Aufnahme 30 sowohl in Steckrichtung S als auch entgegen der Steckrichtung S vorteilhaft bereitstellen.

Wie beispielhaft anhand des zweiten USB-C Steckverbinders 50 gezeigt, kann das Koppelgehäuse 60 des USB-C Steckverbinders 50 mehrere voneinander getrennte Schichten, oder mit anderen Worten, mehrere insbesondere in Radialrichtung R voneinander getrennte Schalen aufweisen.

Beispielsweise kann das Koppelgehäuse 60 eine Festlegungsschale 63 aufweisen, welche die Aufnahme 70 in einer vorbestimmten Position oder in einem vorbestimmten Bereich an dem Koppelgehäuse 60, insbesondere zusammen dem Anschlag 66 einer anderen Schale festlegt. Die Festlegung in der vorbestimmten Position bzw. in dem vorbestimmten Bereich kann insbesondere eine Festlegung entlang der Axialrichtung A oder der Steckrichtung S' sein.

Die Festlegungsschale 63 ist insbesondere ausgebildet, den Aufnahmevorsprung 78 zumindest abschnittsweise entlang der Umfangsrichtung U aufzunehmen, und/oder die Aufnahmecodierung 72 in Umfangsrichtung U zu umgrenzen, insbesondere beidseitig in Umfangrichtung U zu umgrenzen.

Dadurch kann die Aufnahme 70 vorteilhaft drehfest mit der Festlegungsschale 63 verbunden werden. Die Festlegungsschale 63 kann insbesondere relativ zu einer in Radialrichtung äußeren, insbesondere zu der in Radialrichtung äußersten Schale drehbar in dem Koppelgehäuse 60 angeordnet sein. Die Drehbarkeit bezieht sich insbesondere auf eine Drehbarkeit also Rotierbarkeit um die Axialrichtung A. Beispielsweise kann die Festlegungsschale 63 relativ zu der Schale, welche den Anschlag 66 aufweist, drehbar ausgebildet sein, also insbesondere zur in Radialrichtung R nach außen unmittelbar benachbarten Schale.

Dadurch kann eine unmittelbare Drehmomentübertragung von außen auf das Koppelgehäuse 60 und hin zum USB-C Koppelelement 80 vorteilhaft verringert oder verhindert werden. Dadurch kann wiederum eine mögliche von außen wirkende Last auf das USB-C Koppelelement 80 verringert werden, sowie die Langlebigkeit des USB-C Koppelelements 80 vorteilhaft verbessert werden.

Die Koppelgehäuse 20, 60 der ersten und zweiten USB-C Steckverbinders 10, 50 können zusammen insbesondere eine push-pull Verbindung bilden.

Die Koppelgehäuse 20, 60 können im gekoppelten Zustand insbesondere eine formschlüssige Kopplung bilden, welche erst durch Betätigen eines Betätigungselements 68 in einer vorbestimmten Richtung lösbar ist.

Das Koppelgehäuse 20 des ersten USB-C Steckverbinders 10 kann beispielhaft eine oder mehrere erste Kopplungsabschnitte 24 aufweisen, welche jeweils mit einem oder mehreren zweiten Kopplungsabschnitten 64 formschlüssig koppelbar sind. Die formschlüssige Kopplung kann insbesondere nicht-beschädigungsfreie oder nichtzerstörungsfreie Kopplung sein, wenn das Betätigungselement 68 nicht vorbestimmt betätigt wird. Wenn das Betätigungselement 68 auf vorbestimmte Weise betätigt wird, kann die formschlüssige Kopplung insbesondere eine beschädigungsfreie oder zerstörungsfreie Kopplung des Steckverbindersystems 1 sein.

Ein Kopplungsabschnitt 24 der einen oder mehreren ersten Kopplungsabschnitte 24 kann insbesondere eine Aufnahme umfassen, welche ein Eingreifen in Radialrichtung R ermöglicht, insbesondere in Radialrichtung R auswärts.

Ein Kopplungsabschnitt 64 der einen oder mehreren zweiten Kopplungsabschnitte 64 kann insbesondere rückstellfähig auslenkbare Zinken, welche insbesondere zumindest einen Vorsprung in Radialrichtung R aufweisen, umfassen. Der zumindest eine Vorsprung kann sich insbesondere im Wesentlichen in Radialrichtung R auswärts erstrecken.

Im gekoppelten Zustand des Steckverbindersystems 1 greifen die zweiten Kopplungsabschnitte 64 des Koppelgehäuses 60 des zweiten USB-C Steckverbinders 50 insbesondere jeweils in einen der ersten Kopplungsabschnitte 24 des Koppelgehäuses 20 des ersten USB-C Steckverbinders 10 ein.

Dadurch ist das Steckverbindersystem 1 vorteilhaft sicher gekoppelt. Insbesondere können die ersten Kopplungsabschnitte 24 und die zweiten Kopplungsabschnitte 64 im gekoppelten Zustand einen Anschlag entgegen der Steckrichtung S, S' ausbilden,

Das Koppelgehäuse 60 weist insbesondere das Betätigungselement 68 auf, welches insbesondere als Betätigungsschale 68 ausgebildet sein kann.

Wie durch die Figuren 3a, 3b, 5a und 5b verdeutlicht, kann durch Betätigen des Betätigungselements 68 entgegen der Steckrichtung S' der Koppelabschnitt 64 radial einwärts rückstellfähig verformt werden, und insbesondere der Eingriff in den Koppelabschnitt 24 des komplementären Koppelgehäuses 20 gelöst werden. Dann sind die beiden USB-C Steckverbinder 10, 50 vorteilhaft beschädigungsfrei oder zerstörungsfrei voneinander lösbar.

Das Koppelgehäuse 20, 60 kann insbesondere einen Greifabschnitt 21, 61 aufweisen, insbesondere am Betätigungselement 68. Der Greifabschnitt 21, 61 kann insbesondere eine gegenüber dem restlichen Gehäuse erhöhte Rauigkeit aufweisen, beispielsweine eine Randrierung oder Riffelung.

Dadurch ist vorteilhaft die Handhabung der einzelnen Koppelgehäuse 20, 60, insbesondere sowohl beim Koppeln aus auch beim beschädigungsfreien oder zerstörungsfreien Lösen der Kopplung verbessert.

Wie durch die Figuren 4a und 4b beispielhaft anhand der Aufnahme 70 des zweiten USB-C Steckverbinders 50 gezeigt, kann die Öffnung 75 der Aufnahme 70 relativ zum USB-C Koppelelement 80, ein Spiel 91, also einen Freiraum aufweisen. Das Spiel 91 bzw. der Freiraum liegen insbesondere in einem Zustand vor, in welchem das USB-C Koppelelement 80 an oder in der Öffnung 75 angeordnet ist, und welchem das USB-C Koppelement 80 mit der Öffnung 75 und insbesondere dessen Stufenabschnitt 71 in Anschlag ist.

Das Spiel 91 umfasst insbesondere eine Beabstandung zwischen dem USB-Koppelelement 80 und der Öffnung 75, welche im Wesentlichen in Breitenrichtung B ausgebildet ist. Vorzugsweise ist das USB-C Koppelelement 80 im Wesentlichen mit einer Beabstandung bzw. mit dem Spiel 91 in Breitenrichtung B relativ zur Öffnung 75 angeordnet, und insbesondere optional zusätzlich ohne Beabstandung bzw. ohne Spiel 91 in Höhenrichtung H relativ zur Öffnung 75 angeordnet.

Dadurch kann die Vergussmasse 55 vorteilhaft in den Bereich des Spiels 91 bei einem Schritt des Befüllens oder Füllens mit der Vergussmasse 55 eindringen. Dies ermöglicht im Weiteren das USB-C Koppelelement 80 vorteilhaft fest, als auch insbesondere dicht, insbesondere staubdicht und/oder wasserdicht, beispielsweise staubdicht und/oder spritzwasserdicht an der Aufnahme 70 bzw. an dem die Aufnahme 70 haltenden Koppelgehäuse 60 zu fixieren.

Eine Dichtung der Aufnahme 30, 70 gegen das jeweilige Koppelgehäuse 20, 60 kann insbesondere durch eines oder mehrere Dichtelemente, beispielsweise O-Ringe bereitgestellt sein bzw. werden.

Eine Dichtung der zueinander komplementären Koppelgehäuse 20, 60 gegeneinander kann insbesondere durch eines oder mehrere Dichtelemente, sowie optional zusätzlich durch eine Labyrinthstruktur bereitgestellt sein bzw. werden, welche sich insbesondere zwischen den zueinander komplementären Koppelgehäusen 20, 60 im gekoppelten Zustand ausbildet.

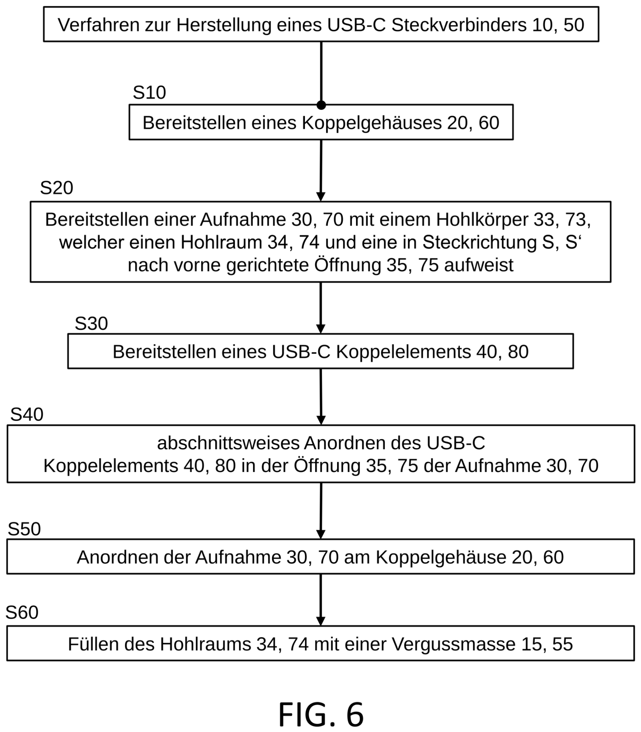

Figur 6 zeigt ein Flussdiagramm eines Verfahrens zur Herstellung eines USB-C Steckverbinders 10, 50, gemäß einer Ausführungsform der vorliegenden Erfindung. Das Verfahren umfasst insbesondere die folgenden Schritte, beispielsweise in der nachfolgend wiedergegebenen Reihenfolge:
S10: Bereitstellen eines Koppelgehäuses 20, 60;
S20: Bereitstellen einer Aufnahme 30, 70 mit einem Hohlkörper 33, 73, welcher einen Hohlraum 34, 74 und eine in Steckrichtung S, S' nach vorne gerichtete Öffnung 35, 75 aufweist;
S30: Bereitstellen eines USB-C Koppelelements 40, 80;
S40: abschnittsweises Anordnen des USB-C Koppelelements 40, 80 in der Öffnung 35, 75 der Aufnahme 30, 70;
S50: Anordnen der Aufnahme 30, 70 am Koppelgehäuse 20, 60;
S60: Füllen des Hohlraums 34, 74 mit einer Vergussmasse.

Insbesondere die Schritte S10, S20 und S30 sind in zueinander beliebiger Reihenfolge durchführbar. Auch die Schritte S40 und S50 sind in zueinander beliebiger Reihenfolge durchführbar. Der Schritt S60 ist insbesondere vor dem Schritt S50 durchführbar, jedoch insbesondere erst nach dem Schritt S40.

Das Verfahren zur Herstellung eines USB-C Steckverbinders bezieht sich insbesondere auf die beiden USB-C Steckverbinder 10, 50 des USB-C Steckverbindersystems 1, wie hierin insbesondere anhand der Figuren 1a bis 5b beschrieben, und umgekehrt.

### Bezugszeichenliste

- 1: USB-C Steckverbindersystem
- 10: erster USB-C Steckverbinder
- 12: Eingriffsbereich
- 15: Vergussmasse
- 20: Koppelgehäuse
- 21: Greifabschnitt
- 22: Aufnahmecodierungsnut
- 23: Fixierring
- 24: erster Kopplungsabschnitt
- 26: Anschlag
- 30: Aufnahme
- 32: Aufnahmecodierung
- 33: Hohlkörper
- 34: Hohlraum
- 35: Öffnung
- 36: Befüllöffnung
- 38: Aufnahmevorsprung
- 40: USB-C Koppelelement
- 42: in Steckrichtung vorderer Teil (des USB-C Koppelelements)
- 44: in Steckrichtung hinterer Teil (des USB-C Koppelelements)
- 50: zweiter USB-C Steckverbinder
- 51: rückstellfähiges Element
- 55: Vergussmasse
- 60: Koppelgehäuse
- 61: Greifabschnitt
- 62: Aufnahmecodierung
- 63: Festlegungsschale
- 64: zweiter Kopplungsabschnitt
- 66: Anschlag
- 68: Betätigungselement
- 70: Aufnahme
- 71: Stufenabschnitt
- 72: Nut
- 73: Hohlkörper
- 74: Hohlraum
- 75: Öffnung
- 76: Befüllöffnung
- 78: Aufnahmevorsprung
- 79: Nut
- 80: USB-C Koppelelement
- 82: in Steckrichtung vorderer Teil (des USB-C Koppelelements)
- 84: in Steckrichtung hinterer Teil (des USB-C Koppelelements)
- 91: Spiel
- A: Axialrichtung
- B: Breitenrichtung
- H: Höhenrichtung
- R: Radialrichtung
- S, S': Steckrichtung
- U: Umfangsrichtung
- S10-S60: Schritte eines Verfahrens zur Herstellung eines USB-C Steckverbinders

## Patentansprüche

1. USB-C Koppelvorrichtung, umfassend:
- ein Koppelgehäuse (20; 60);
- eine Aufnahme (30; 70), welche an einem vorderen Abschnitt des Koppelgehäuses (20; 60) gehalten ist, und welche ausgebildet ist, ein USB-C Koppelelement (40; 80), welches einen USB-C Anschluss aufweist, aufzunehmen;
-- wobei die Aufnahme (30; 70) einen Hohlkörper (33; 73) mit einer Öffnung (35; 75) in Steckrichtung (S; S') der Koppelvorrichtung aufweist,
-- wobei das USB-C Koppelelement (40; 80) abschnittsweise in der Öffnung (35; 75) des Hohlkörpers (33; 73) anordenbar ist, so dass das USB-C Koppelelement (40; 80) zumindest teilweise in einen Hohlraum (34; 74) des Hohlkörpers (33; 73) ragt, und
-- wobei der Hohlkörper (33; 73) zumindest abschnittsweise mit einer Vergussmasse (15; 55) befüllbar ist, derart, dass das USB-C Koppelelement (40; 80) fixiert ist.

2. USB-C Koppelvorrichtung nach Anspruch 1, wobei die Aufnahme (70) an einer radial äußeren Seite eine Nut (79) aufweist, welche sich zumindest abschnittsweise im Wesentlichen in Umfangsrichtung (U) erstreckt.

3. USB-C Koppelvorrichtung nach Anspruch 1 oder 2, wobei die Aufnahme (30; 70) rückstellfähig am Koppelgehäuse (20; 60) angeordnet ist.

4. USB-C Koppelvorrichtung nach einem der vorangehenden Ansprüche, wobei das USB-C Koppelelement (80) zumindest abschnittsweise mit einem Spiel (91) in der Öffnung (75) der Aufnahme (70) anordenbar ist.

5. USB-C Koppelvorrichtung nach einem der vorangehenden Ansprüche, wobei die Öffnung (75) der Aufnahme (70) derart ausgebildet ist, dass in einer Breitenrichtung (B) des USB-C Koppelelements (80) die Öffnung (75) ein Spiel gegenüber dem USB-C Koppelelement (80) aufweist, und in einer zur Breitenrichtung (B) im Wesentlichen senkrechten Höhenrichtung (H) des USB-C Koppelelements (80) die Öffnung (75) kein Spiel gegenüber dem USB-C Koppelelement (80) aufweist.

6. USB-C Koppelvorrichtung nach einem der vorangehenden Ansprüche, wobei das USB-C Koppelelement (40; 80) berührgeschützt in dem Koppelgehäuse (20; 60) anordenbar ist,
wobei das USB-C Koppelelement (40; 80) insbesondere nach der Schutzart IP 50 an der Koppelvorrichtung anordenbar ist.

7. USB-C Koppelvorrichtung nach einem der vorangehenden Ansprüche, wobei das USB-C Koppelelement (40; 80) eine weibliche USB-C Buchse oder einen männlichen USB-C Stecker an einer in Steckrichtung (S; S') vorderen Seite aufweist, und/oder
zumindest eines von einer Leiterplatte, einer weiblichen USB-C Buchse, einem männlichen USB-C Stecker, und einem Datenkabel an einer in Steckrichtung (S; S') hinteren Seite aufweist.

8. USB-C Koppelvorrichtung nach einem der vorangehenden Ansprüche, wobei das Koppelgehäuse (20; 60) schalenförmig, mit mehreren Schalen entlang der Radialrichtung (R), ausgebildet ist, und wobei die Aufnahme (30; 70) relativ zur radial äußersten Schale des Koppelgehäuses (20; 60) drehbar gelagert ist.

9. USB-C Koppelvorrichtung nach Anspruch 8, wobei eine Schale des Koppelgehäuses (20; 60), welche im Wesentlichen in Radialrichtung (R) zwischen der Aufnahme (30; 70) und der radial äußersten Schale des Koppelgehäuses (20; 60) angeordnet ist, relativ zur radial äußersten Schale drehbar ist.

10. USB-C Koppelvorrichtung nach Anspruch 9, wobei die Aufnahme (30; 70) drehfest in der Schale des Koppelgehäuses (20; 60) angeordnet ist, welche im Wesentlichen in Radialrichtung (R) zwischen der Aufnahme (30; 70) und der radial äußersten Schale des Koppelgehäuses (20; 60) angeordnet ist.

11. USB-C Koppelvorrichtung nach einem der vorangehenden Ansprüche, wobei die Vergussmasse einen die Wärmeleitfähigkeit der Vergussmasse steigernden Füllstoff umfasst.

12. USB-C Koppelvorrichtung nach einem der vorangehenden Ansprüche, wobei das Koppelgehäuse (20; 60) eine Push-Pull Funktion bereitstellt.

13. USB-C Steckverbinder (10; 50), insbesondere Rundsteckverbinder, umfassend:
- ein Koppelgehäuse (20; 60);
- eine Aufnahme (30; 70), welche an einem vorderen Abschnitt des Koppelgehäuses (20; 60) gehalten ist, und
- ein USB-C Koppelelement (40; 80), welches einen USB-C Anschluss aufweist;
-- wobei die Aufnahme (30; 70) einen Hohlkörper (33; 73) mit einer Öffnung (35; 75) in Steckrichtung (S; S') des USB-C Steckverbinders (10; 50) aufweist,
-- wobei das USB-C Koppelelement (40; 80) abschnittsweise in der Öffnung (35; 75) des Hohlkörpers (33; 73) angeordnet ist, derart, dass das USB-C Koppelelement (40; 80) zumindest teilweise in einen Hohlraum (34; 74) des Hohlkörpers (33; 73) ragt, und
-- wobei der Hohlkörper (33; 73) zumindest abschnittsweise mit einer Vergussmasse (15; 55) befüllt ist.

14. USB-C Steckverbindersystem (1), umfassend:
- einen USB-C Steckverbinder (10; 50) nach Anspruch 13, und
- eine zum USB-C Koppelelement (40; 80) des USB-C Steckverbinders (10; 50) komplementäre Koppeleinheit, welche einen USB-C Anschluss umfasst, welches mit dem USB-C Koppelelement (40; 80) elektrisch leitfähig gekoppelt ist.

15. Verfahren zur Herstellung eines USB-C Steckverbinders (10; 50), wobei das Verfahren die Schritte umfasst:
- Bereitstellen eines Koppelgehäuses (20; 60);
- Bereitstellen einer Aufnahme (30; 70) mit einem Hohlkörper (33; 73), welcher einen Hohlraum (34; 74) und eine in Steckrichtung (S; S') nach vorne gerichtete Öffnung (35; 75) aufweist;
- Bereitstellen eines USB-C Koppelelements (40; 80);
- abschnittsweises Anordnen des USB-C Koppelelements (40; 80) in der Öffnung (35; 75) der Aufnahme (30; 70);
- Anordnen der Aufnahme (30; 70) am Koppelgehäuse (20; 60);
- Füllen des Hohlraums (34; 74) mit einer Vergussmasse (15; 55).
